# EUROPEAN PATENT APPLICATION

(11) **EP 4 418 087 A1**
(43) Date of publication of application: **21.08.2024**
(21) Application number: 24156812.0
(22) Date of filing: 09.02.2024
(51) Int. Cl.: G06F 3/044, G06F 3/041

(54) **DISPLAY DEVICE**

(30) Priority: 20.02.2023 KR 20230022225; 24.03.2023 KR 20230038655
(71) Applicant: Samsung Display Co., Ltd., Gyeonggi-Do (KR)
(72) Inventor: Park, Yong-Hwan, Yongin-si, Gyeonggi-Do (KR); Han, Hyeyun, Yongin-si, Gyeonggi-Do (KR); Ko, Gyung-Min, Yongin-si, Gyeonggi-Do (KR)
(74) Representative: Gulde & Partner

(57) **Abstract**

A display device including: a display panel including a plurality of light emitting regions; and an input sensing layer disposed on the display panel, and including a plurality of sensing units, wherein the plurality of sensing units include: a plurality of mesh lines in which a plurality of openings respectively overlapping the plurality of light emitting regions are defined; and a plurality of visual patterns protruding from the plurality of mesh lines towards one of the plurality of light emitting regions or recessed away from one of the plurality of light emitting regions, wherein: a cut portion connecting two adjacent openings among the plurality of openings is provided in the plurality of mesh lines; and at least one of the plurality of visual patterns overlaps the cut portion in one direction.

## Description

### Technical Field

The present disclosure herein relates to a display device, and more particularly, to a display device with improved visibility and improved sensing performance.

### Discussion of Related Art

Multimedia devices such as televisions, mobile phones, tablets, navigation system units, and game consoles may include a display screen that presents images to users. These display devices may include a display panel that generates images, and an input sensor that detects user touch.

The input sensor may include a conductor to detect external inputs. When this conductor is positioned on the display panel, it can influence the luminous efficiency of the display device or its external light reflectance.

### SUMMARY

The present disclosure provides a display device with improved visibility and sensing performance.

An embodiment of the inventive concept provides a display device including: a display panel including a plurality of light emitting regions; and an input sensing layer disposed on the display panel, and including a plurality of sensing units, wherein the plurality of sensing units include: a plurality of mesh lines in which a plurality of openings respectively overlapping the plurality of light emitting regions are defined; and a plurality of visual patterns protruding from the plurality of mesh lines towards one of the plurality of light emitting regions or recessed away from one of the plurality of light emitting regions, wherein: a cut portion connecting two adjacent openings among the plurality of openings is provided in the plurality of mesh lines; and at least one of the plurality of visual patterns overlaps the cut portion in one direction.

Each of the plurality of visual patterns protrudes towards one of the plurality of light emitting regions.

A height by which each of the plurality of visual patterns protrudes from the plurality of mesh lines is about 1 micrometer to about 5 micrometers, preferably 2 micrometers to 4 micrometers, more preferably 3 micrometers.

Each of the plurality of visual patterns has a semi-circular or semi-elliptical shape.

Each of the plurality of visual patterns has a rectangular shape with rounded corners.

A height by which each of the plurality of visual patterns protrudes from the plurality of mesh lines is less than a distance from each of the plurality of mesh lines to each of the plurality of light emitting regions.

Each of the plurality of visual patterns is recessed from one of the plurality of light emitting regions.

The plurality of visual patterns include: a plurality of protruding visual patterns that protrude towards one of the plurality of light emitting regions; and a plurality of recessed visual patterns that are recessed away from one of the plurality of light emitting regions.

The plurality of mesh lines include a first mesh line and a second mesh line surrounding one light emitting region among the plurality of light emitting regions, wherein: the first mesh line is extended in a first direction; and the second mesh line is extended in a second direction intersecting the first direction.

The plurality of visual patterns include: a first visual pattern protruding or recessed from the first mesh line in the second direction; and a second visual pattern protruding or recessed from the second mesh line in the first direction.

The first visual pattern includes: a 1-1 visual pattern protruding from the first mesh line; and a 1-2 visual pattern protruding from the first mesh line, and disposed side by side with the 1-1 visual pattern in the first direction; and the second visual pattern includes: a 2-1 visual pattern protruding from the second mesh line; and a 2-2 visual pattern protruding from the second mesh line, and disposed side by side with the 2-1 visual pattern in the second direction.

Each of the plurality of visual patterns includes: a first visual surface extended from one side of one of the plurality of mesh lines, and having a first slope; and a second visual surface extended from the first visual surface, and having a second slope different from the first slope.

The plurality of light emitting regions include: a first light emitting region configured to emit first color light; a second light emitting region configured to emit second color light different from the first color light; and a third light emitting region configured to emit third color light different from the first color light and the second color light, wherein a wavelength range of the third color light is smaller than a wavelength range of the first color light and a wavelength range of the second color light.

The first light emitting region and the second light emitting region are alternately arranged with each other along a first direction; and the third light emitting region is spaced apart from the first light emitting region and the second light emitting region along a second direction intersecting the first direction, wherein each of the plurality of mesh lines is extended along any one of the first direction and the second direction.

The first light emitting region and the third light emitting region are alternately arranged with each other along a first direction; and the third light emitting region is spaced apart from the first light emitting region and the second light emitting region along a second direction intersecting the first direction, wherein at least some of the plurality of mesh lines are extended along a diagonal direction, which is a direction between the first direction and the second direction.

The plurality of sensing units include: first sensing units extended in a first direction; and second sensing units extended in a second direction intersecting the first direction, wherein the cut portion includes a boundary cut portion provided between one first sensing unit among the first sensing units and one second sensing unit among the second sensing units.

The cut portion further includes an additional cut portion inside of at least one of the first sensing units or the second sensing units.

The input sensing layer includes: a first sensing insulation layer disposed on the display panel; a second sensing insulation layer disposed on the first sensing insulation layer; and a sensing conductive layer disposed in an upper portion of at least one of the first sensing insulation layer or the second sensing insulation layer, wherein the sensing conductive layer includes the plurality of sensing units.

An embodiment of the inventive concept provides a display device including: a display panel including a plurality of light emitting regions; and an input sensing layer disposed on the display panel, and including a plurality of sensing units, wherein the plurality of sensing units include: a plurality of mesh lines in which a plurality of openings respectively overlapping the plurality of light emitting regions are defined; and a plurality of visual patterns disposed on one side of at least one of the plurality of mesh lines, wherein: the plurality of mesh lines include a first mesh line and a second mesh line surrounding one light emitting region among the plurality of light emitting regions, wherein: the first mesh line is extended in a first direction; and the second mesh line is extended in a second direction intersecting the first direction, and the plurality of visual patterns include: a first visual pattern protruding or recessed from the first mesh line in the second direction; and a second visual pattern protruding or recessed from the second mesh line in the first direction.

An embodiment of the inventive concept provides a display device including: a display panel including a first light emitting region, a second light emitting region, and a third light emitting region; and an input sensing layer disposed on the display panel, and including a plurality of sensing units, wherein the plurality of sensing units include: a plurality of mesh lines in which a first opening, a second opening, and a third opening respectively overlapping the first light emitting region, the second light emitting region, and the third light emitting region are defined; and a plurality of visual patterns which are disposed on one side of at least one of the plurality of mesh lines, and at least some of which have round shapes, wherein the plurality of visual patterns include: a first group visual pattern disposed in mesh lines surrounding the first light emitting region among the plurality of mesh lines; a second group visual pattern disposed in mesh lines surrounding the second light emitting region among the plurality of mesh lines; and a third group visual pattern disposed in mesh lines surrounding the third light emitting region among the plurality of mesh lines.

### BRIEF DESCRIPTION OF THE DRAWINGS

In the drawings:
FIG. 1 is a perspective view of a display device according to an embodiment of the inventive concept;
FIG. 2 is a cross-sectional view of a display module according to an embodiment of the inventive concept;
FIG. 3 is a plan view of a display panel according to an embodiment of the inventive concept;
FIG. 4 is a cross-sectional view of a display module according to an embodiment of the inventive concept;
FIG. 5 is a plan view of an input sensing layer according to an embodiment of the inventive concept;
FIG. 6 is an enlarged view of a sensing unit according to an embodiment of the inventive concept;
FIG. 7 is a plan view of a portion of a mesh pattern according to an embodiment of the inventive concept;
FIG. 8A, 8B, 8C, 8D, 8E and 8F are each a plan view of a portion of a mesh pattern according to an embodiment of the inventive concept;
FIG. 9 is a plan view of a portion of a mesh pattern according to an embodiment of the inventive concept;
FIG. 10A and FIG. 10B are each a plan view of a portion of a mesh pattern according to an embodiment of the inventive concept; and
FIG. 11 is a plan view of a portion of a mesh pattern according to an embodiment of the inventive concept.

### DETAILED DESCRIPTION OF THE EMBODIMENTS

In the present disclosure, when an element (or a region, a layer, a portion, etc.) is referred to as being "on," "connected to," or "coupled to" another element, it may mean that the element is directly disposed on/connected to/coupled to the other element, or that a third element is disposed therebetween.

Additionally, in the present disclosure, being "directly disposed" may mean that there is no layer, film, region, plate, or the like added between a portion of a layer, a film, a region, a plate, or the like and other portions. For example, being "directly disposed" may mean being disposed without additional members such as an adhesive member between two layers or two members.

Like reference numerals may refer to like elements. Additionally, in the drawings, the thickness, the ratio, and the dimensions of elements may be exaggerated for a more effective description of the technical contents illustrated therein. The term "and/or" includes any and all combinations of one or more of which associated elements may define.

It will be understood that, although the terms "first," "second," etc. may be used herein to describe various elements, these elements should not be limited by these terms. These terms are used to distinguish one element from another. For example, a first element may be referred to as a second element, and a second element may also be referred to as a first element in a similar manner. The terms of a singular form may include plural forms unless the context clearly indicates otherwise.

In addition, terms such as "below," "lower," "above," "upper," and the like are used to describe the relationship of the elements shown in the drawings. The terms are used as a relative concept and are described with reference to the direction indicated in the drawings.

It should be understood that the term "comprise," or "have" is intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined, all terms (including technical and scientific terms) used herein have the same meaning as commonly understood by one of ordinary skill in the art to which the inventive concept pertains. It is also to be understood that terms such as terms defined in commonly used dictionaries should be interpreted as having meanings consistent with the meanings in the context of the related art, and should not be interpreted in an ideal or overly formal sense unless explicitly defined herein.

Hereinafter, embodiments of the inventive concept will be described with reference to the accompanying drawings.

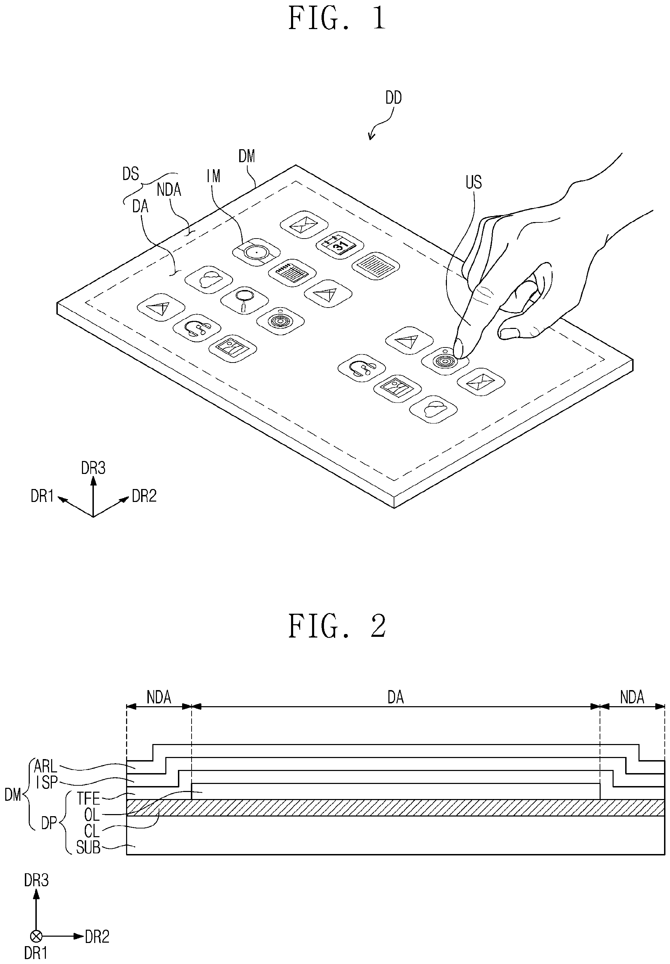

FIG. 1 is a perspective view of a display device DD according to an embodiment of the inventive concept.

The display device DD may be a device which is activated in response to an electrical signal and displays an image IM. For example, the display device DD may be a largesized device such as a television and an external billboard as well as a small-and-medium-sized device such as a monitor, a mobile phone, a tablet, a navigation system unit, and a game console. However, the above-described embodiments of the display device DD are merely exemplary, and the display device DD is not limited to any one thereof.

Referring to FIG. 1, the display device DD may include a display module DM which displays the image IM and senses an external input. The display module DM may have a rectangular shape which has long sides extended in a first direction DR1 and short sides extended in a second direction DR2 which intersects the first direction DR1 on a plane. However, the embodiment of the inventive concept is not limited thereto, and the display module DM may have various shapes such as a circular shape and a polygonal shape.

In the present embodiment, a third direction DR3 may be a direction substantially perpendicular to a plane formed by the first direction DR1 and the second direction DR2. The front surface (or upper surface) and the rear surface (or lower surface) of members constituting the display device DD may oppose each other in the third direction DR3. Additionally, a normal direction of each of the front surface and the rear surface may be substantially parallel to the third direction DR3. A separation distance between the front surface and the rear surface, which is defined along the third direction DR3, may correspond to the thickness of a member.

In the present disclosure, "on a plane" may be a state viewed in the third direction DR3. In the present disclosure, "on a cross-section" may be a state viewed in the first direction DR1 or the second direction DR2. Directions indicated by the first to third directions DR1, DR2, and DR3 are a relative concept, and may be converted to different directions.

The display device DD may be rigid or flexible. Being "flexible" refers to having properties of being able to be bent, which may include a structure that may be completely folded to a structure capable of being bent to a degree of a few nanometers. For example, a flexible display device DD may include a curved device, a rollable device, a slidable device, or a foldable device.

An upper surface of the display module DM may be defined as a display surface DS, and the display surface DS may have a plane formed by the first direction DR1 and the second direction DR2. The display module DM may provide a generated image IM to a user through the display surface DS. The display surface DS may include a display region DA and a non-display region NDA.

The display region DA may be a region in which the image IM is displayed, and the non-display region NDA may be a region in which the image IM is not displayed. The non-display region NDA may be adjacent to the display region DA. For example, the non-display region NDA may surround the display region DA. As another example, the non-display region NDA may be disposed on less than all sides of the display region DA. The non-display region NDA may correspond to a region printed with a predetermined color, and may form the edge of the display module DM.

The display module DM may sense an input applied from the outside of the display module DM. An external input may include various forms of inputs such as force, pressure, temperature, or light. In the present embodiment, the external input is illustrated as a user's hand US applied to the front surface of the display device DD. However, this is merely an example, and the external input may include a contact by a pen or an input applied in close proximity to the display device DD such as hovering.

FIG. 2 is a cross-sectional view of the display module DM according to an embodiment of the inventive concept.

Referring to FIG. 2, the display module DM includes a display panel DP, an input sensing layer ISP. The display module DM may further include an anti-reflection layer ARL. The display panel DP may include a base substrate SUB, a circuit element layer CL, a display element layer OL, and a thin film encapsulation layer TFE. The base substrate SUB, the circuit element layer CL, the display element layer OL, and the thin film encapsulation layer TFE may be sequentially stacked.

The display panel DP according to an embodiment may be a light emitting-type display panel, and is not particularly limited. For example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot, a quantum load, and the like. Hereinafter, the display panel DP will be described as the organic light emitting display panel.

The base substrate SUB may provide a base surface on which the circuit element layer CL is disposed. The base substrate SUB may be a rigid substrate, or a flexible substrate capable of bending, folding, rolling, or the like. The base substrate SUB may be a glass substrate, a metal substrate, a polymer substrate, or the like. However, the embodiment of the inventive concept is not limited thereto, and the base substrate SUB may be an inorganic layer, an organic layer, or a composite material layer.

The base substrate SUB may have a multi-layered structure. For example, the base substrate SUB may include synthetic resin layers and a multi-layered or single-layered inorganic layer disposed between the synthetic resin layers. The synthetic resin layer may include an acrylic resin, a methacrylic resin, polyisoprene, a vinyl-based resin, an epoxy-based resin, a urethane-based resin, a cellulose-based resin, a siloxane-based resin, a polyamide-based resin, a perylene-based resin, or the like, and is not particularly limited.

The circuit element layer CL may be disposed on the base substrate SUB. The circuit element layer CL may include an insulation layer, a semiconductor pattern, and a conductive pattern. The insulation layer, the semiconductor pattern, and the conductive pattern included in the circuit element layer CL may form driving elements, signal lines, and pads in the circuit element layer CL.

The display element layer OL may be disposed on the circuit element layer CL. The display element layer OL may include light emitting elements disposed in the display region DA. The light emitting elements may include an organic light emitting element, an inorganic light emitting element, a micro-light emitting diode (LED), a nano-LED, or the like, and are not particularly limited. The light emitting elements of the display element layer OL may be electrically connected to the driving elements of the circuit element layer CL, and may generate light in the display region DA according to a signal provided by the driving elements.

The thin film encapsulation layer TFE may be disposed on the display element layer OL and encapsulate the light emitting elements. The thin film encapsulation layer TFE may also contact the circuit element layer CL. The thin film encapsulation layer TFE may include at least one thin film for improving optical efficiency of the display element layer OL, or for protecting the display element layer OL. The thin film encapsulation layer TFE may include at least one of an inorganic film or an organic film.

The input sensing layer ISP may be disposed on the display panel DP. The input sensing layer ISP may be formed through a continuous process on a base surface provided by the display panel DP. The input sensing layer ISP may be directly disposed on the display panel DP without a separate adhesive layer. For example, the input sensing layer ISP may be in direct contact with the thin film encapsulation layer TFE. However, the embodiment of the inventive concept is not limited thereto, and the input sensing layer ISP may be coupled on the display panel DP through an adhesive layer.

The input sensing layer ISP may sense an external input and provide an input signal including information on the external input to enable the display panel DP to display an image corresponding to the external input. The input sensing layer ISP may be driven using various techniques, such as a capacitive technique, a resistive film technique, an infrared light technique, a sonic technique, or a pressure technique, and the method for driving the input sensing layer ISP is not limited to any one embodiment as long as the method allows an external input to be sensed. In the present embodiment, the input sensing layer ISP is described as an input sensing panel driven in a capacitive technique.

The anti-reflection layer ARL may be disposed on the input sensing layer ISP. The anti-reflection layer ARL may be directly disposed on the input sensing layer ISP. However, the embodiment of the inventive concept is not limited thereto, and the anti-reflection layer ARL may be coupled to the input sensing layer ISP through a separate adhesive layer. The anti-reflection layer ARL may reduce reflectance of external light incident from the outside of the display device DD (see FIG. 2).

In an embodiment, the anti-reflection layer ARL may include a phase retarder and/or a polarizer. The phase retarder and the polarizer may each be provided as a film type or a liquid crystal coating type. The phase retarder and the polarizer may be provided in the form of a polarizing film.

In an embodiment, the anti-reflection layer ARL may include color filters. The color filters may be disposed corresponding to the arrangement and emission colors of pixels included in the display panel DP. The color filters may filter incident external light to the same color as the color emitted by a corresponding pixel. The anti-reflection layer ARL may further include a light blocking pattern disposed adjacent to the color filters.

FIG. 2 illustrates an embodiment in which the input sensing layer ISP and the anti-reflection layer ARL are sequentially disposed on the display panel DP, but the embodiment of the inventive concept is not limited thereto. For example, the stacking order of the anti-reflection layer ARL and the input sensing layer ISP may change. Furthermore, FIG. 2 illustrate an embodiment in which the display region DA overlaps the display element layer OL while the non-display region NDA does not overlap the display element layer OL.

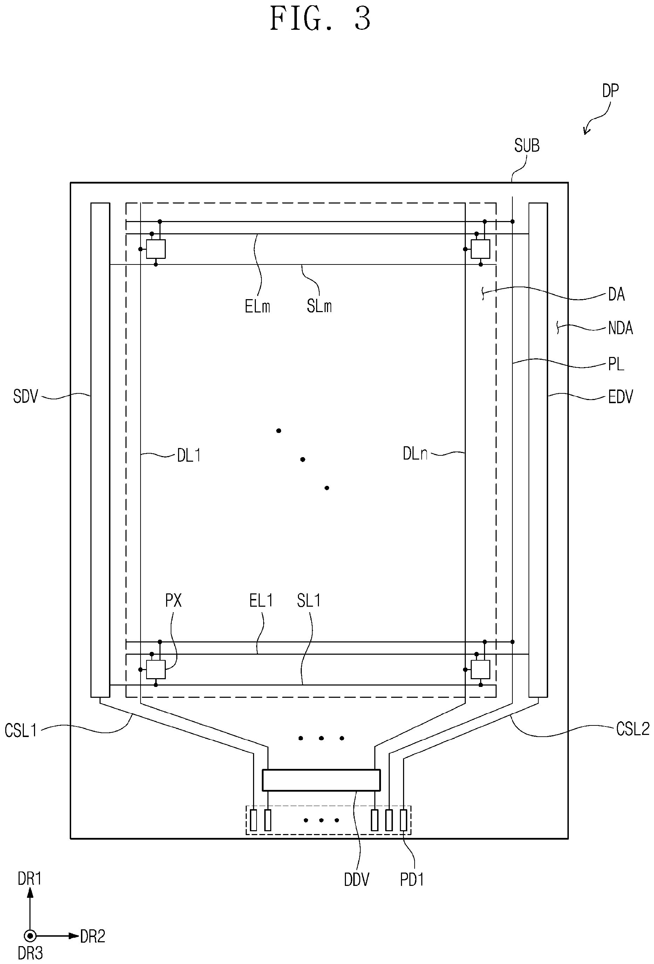

FIG. 3 is a plan view of the display panel DP according to an embodiment of the inventive concept.

Referring to FIG. 3, the display panel DP may include the base substrate SUB, pixels PX, signal lines SL1 to SLm, DL1 to DLn, EL1 to ELm, CSL1, CSL2, and PL electrically connected to the pixels PX, a scan driver SDV, a data driver DDV, and an emission driver EDV.

The base substrate SUB may provide a base surface on which elements and lines of the display panel DP are disposed on a plane parallel to each of the first direction DR1 and the second direction DR2. The base substrate SUB may include a display region DA and a non-display region NDA of the display panel DP described above.

The display region DA may be a region in which the pixels PX are disposed and which an image is displayed. The non-display region NDA may be a region adjacent to the display region DA and not display an image. In the non-display region NDA, the scan driver SDV, the data driver DDV, and the emission driver EDV for driving the pixels PX may be disposed. However, to reduce the area of the non-display region NDA, at least one of the scan driver SDV, the data driver DDV, or the emission driver EDV may be disposed in the display region DA.

Each of the pixels PX may include a pixel driving circuit composed of transistors (e.g., a switching transistor, a driving transistor, etc.) and at least one capacitor and a light emitting element electrically connected to the pixel driving circuit. The pixels PX may emit light in response to an electrical signal applied to each of the pixels PX, thereby displaying an image in the display region DA. Some of the pixels PX may include a transistor disposed in the non-display region NDA, and are not limited to any one embodiment.

The signal lines SL1 to SLm, DL1 to DLn, EL1 to ELm, CSL1, CSL2, and PL may include scan lines SL1 to SLm, data lines DL1 to DLn, emission lines EL1 to ELm, first and second control lines CSL1 and CSL2, and a power line PL. Here, m and n are natural numbers.

The data lines DL1 to DLn may be insulated from the scan lines SL1 to SLm and the light emission lines EL1 to ELm and may intersect the scan lines SL1 to SLm and the light emission lines EL1 to ELm on a plane. For example, the scan lines SL1 to SLm may be extended in the second direction DR2 and may be electrically connected to the scan driver SDV. The data lines DL1 to DLn may be extended in the first direction DR1 and may be electrically connected to the data driver DDV. The emission lines EL1 to ELm may be extended in the second direction DR2 and may be electrically connected to the emission driver EDV.

The power line PL may include a portion extended in the first direction DR1 and a portion extended in the second direction DR2. The portion of the power line PL extended in the first direction DR1 may be disposed in the non-display region NDA. The portion of the power line PL extended in the second direction DR2 may be electrically connected to the portion of the power line PL extended in the first direction DR1. The portion of the power line PL extended in the second direction DR2 may be slanted. The portion of the power line PL extended in the second direction DR2 may be disposed on a layer different from that of the portion of the power line PL extended in the first direction DR1. For example, the portion of the power line PL extended in the second direction DR2 portion of the power line PL extended in the second direction DR2 may be connected through a contact hole, or may have a shape of a single body with the portion of the power line PL extended in the first direction DR1 on the same layer.

The first control line CSL1 may be electrically connected to the scan driver SDV. The second control line CSL2 may be electrically connected to the emission driver EDV.

First pads PD1 may be disposed adjacent to a lower end of the non-display region NDA. The first pads PD1 may be disposed closer to a lower end of the display panel DP than the data driver DDV. The first pads PD1 may be spaced apart from each other along the second direction DR2.

The first pads PD1 may be display pads that are electrically connected to the pixels PX. Each of the first pads PD1 may be connected to a corresponding signal line among the signal lines SL1~SLm, DL1~DLn, EL1~ELm, CSL1, CSL2, and PL. For example, the first pads PD1 may be electrically connected to the power line PL, the first control line CSL1, the second control line CSL2, and the data lines DL1 to DLn.

The scan driver SDV may generate scan signals in response to a scan control signal. The scan signals may be applied to the pixels PX through the scan lines SL1 to SLm. The data driver DDV may generate data voltages corresponding to image signals in response to a data control signal. The data voltages may be applied to the pixels PX through the data lines DL1 to DLn. The emission driver EDV may generate emission signals in response to an emission control signal. The emission signals may be applied to the pixels PX through the emission lines EL1 to ELm.

The pixels PX may be provided with the data voltages in response to the scan signals. The pixels PX may generate an image by emitting light of luminance corresponding to the data voltages in response to the emission signals. In other words, the pixels PX can produce an image by emitting light at a luminance that corresponds to the data voltages by reacting to the emission signals. The emission duration of the pixels PX may be controlled by the emission signals.

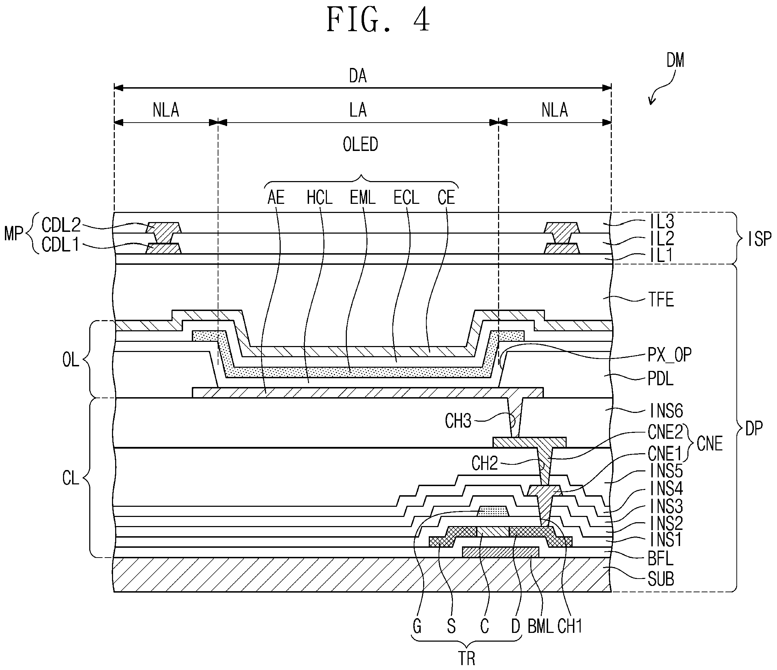

FIG. 4 is a cross-sectional view of the display module DM according to an embodiment of the inventive concept. FIG. 4 illustrates a cross-section of the display module DM corresponding to one pixel PX illustrated in FIG. 3.

Referring to FIG. 4, the display module DM includes the display panel DP and the input sensing layer ISP.

The display panel DP may include a plurality of pixels PX (see FIG. 3). The pixel PX (see FIG. 3) may include a transistor TR and a light emitting element OLED. The transistor TR and the light emitting element OLED may be disposed on the base substrate SUB. FIG. 4 illustrates one transistor TR, but the pixel PX (see FIG. 3) may include a plurality of transistors for driving the light emitting element OLED, and at least one capacitor.

The circuit element layer CL may be disposed on the base substrate SUB. The circuit element layer CL may include a shielding electrode BML, the transistor TR, connection electrodes CNE, and a plurality of insulation layers BFL and INS1, INS2, INS3, INS4, INS5 and INS6. The plurality of insulation layers BFL and INS1 to INS6 may include a buffer layer BFL and first to sixth transistors INS1 to INS6. However, the stacking structure of the circuit element layer CL illustrated in FIG. 4 is only an example, and depending on the configuration of the pixel PX (see FIG. 3) and the process of the circuit element layer CL, the stacking structure of the circuit element layer CL may be changed.

The shielding electrode BML may be disposed on the base substrate SUB. The shielding electrode BML may overlap the transistor TR. The shielding electrode BML may protect the transistor TR by blocking light incident to the transistor TR from a lower portion of the display panel DP. The shielding electrode BML may include a conductive material. In an embodiment, the shielding electrode BML may be connected to the power line PL (see FIG. 3) to be applied with a voltage. When the voltage is applied to the shielding electrode BML, a threshold voltage of the transistor TR disposed on the shielding electrode BML may be maintained. However, the embodiment of the inventive concept is not limited thereto, and the shielding electrode BML may be a floating electrode. In an embodiment, the shielding electrode BML may be omitted.

The buffer layer BFL may be disposed on the base substrate to cover the shielding electrode BML. The buffer layer BFL may include an inorganic layer. The buffer layer BFL may improve a coupling force between a semiconductor pattern or conductive pattern disposed on the buffer layer BFL and the base substrate SUB.

The transistor TR may include a source S, a channel C, a drain D, and a gate G. The source S, the channel C, and the drain D of the transistor TR may be formed from a semiconductor pattern. The semiconductor pattern of the transistor TR may include polysilicon, amorphous silicon, or a metal oxide, and is not limited to any one embodiment as long as it has semiconductor properties.

The semiconductor pattern may include a plurality of regions separated according to the magnitude of their conductivity. In the semiconductor pattern, a region doped with a dopant or a region in which a metal oxide is reduced may have a high conductivity, and may serve as a source electrode or a drain electrode of the transistor TR. In the semiconductor pattern, a region having a high conductivity may correspond to the source S or the drain D of the transistor TR. A region non-doped or doped to a low concentration or having a low conductivity due to the nonreduction of a metal oxide may correspond to the channel C (or an active) of the transistor TR.

The first insulation layer INS1 may be disposed on the buffer layer BFL while covering the semiconductor pattern of the transistor TR. The gate G of the transistor TR may be disposed on the first insulation layer INS1. The gate G may overlap the channel C of the transistor TR. In an embodiment, the gate G may serve as a mask in a process of doping the semiconductor pattern of the transistor TR.

The second insulation layer INS2 may be disposed on the first insulation layer INS1 while covering the gate G. The third insulation layer INS3 may be disposed on the second insulation layer INS2.

The connection electrodes CNE may include a first connection electrode CNE1 and a second connection electrode CNE2 for electrically connecting the transistor TR and the light emitting element OLED. However, an embodiment of the connection electrodes CNE which connect the transistor TR and the light emitting element OLED is not limited thereto, and one of the first and second connection electrodes CNE1 and CNE2 may be omitted, or an additional connection electrode may be further included. For example, a third connection electrode may be provided above the second connection electrode CNE2 to connect the second connection electrode CNE2 to the light emitting element OLED.

The first connection electrode CNE1 may be disposed on the third insulation layer INS3. The first connection electrode CNE1 may be connected to the drain D through a first contact hole CH1 passing through the first to third insulation layers INS1 to INS3. The fourth insulation layer INS4 may be disposed on the third insulation layer INS3 while covering the first connection electrode CNE1. The fifth insulation layer INS5 may be disposed on the fourth insulation layer INS4.

The second connection electrode CNE2 may be disposed on the fifth insulation layer INS5. The second connection electrode CNE2 may be connected to the first connection electrode CNE1 through a second contact hole CH2 passing through the fourth and fifth insulation layers INS4 and INS5. The sixth insulation layer INS6 may be disposed on the fifth insulation layer INS5 while covering the second connection electrode CNE2.

The first to sixth insulation layers INS1 to INS6 may each include an inorganic layer or an organic layer. For example, the inorganic layer may include at least one of an aluminum oxide, a titanium oxide, a silicon oxide, a silicon oxynitride, a zirconium oxide, or a hafnium oxide. The organic layer may include at least one of an acrylic resin, a methacrylic resin, polyisoprene, a vinyl-based resin, an epoxy-based resin, a urethane-based resin, a cellulose-based resin, a siloxane-based resin, a polyamide-based resin, or a perylene-based resin.

The display element layer OL may include a pixel definition film PDL and the light emitting element OLED. The light emitting element OLED may include a first electrode AE, a hole control layer HCL, an electron control layer ECL, a light emitting layer EML, and a second electrode CE.

The first electrode AE may be disposed on the sixth insulation layer INS6. The first electrode AE may be connected to the second connection electrode CNE2 through a third contact hole CH3 passing through the sixth insulation layer INS6. The first electrode AE may be electrically connected to the drain D of the transistor TR through the first and second connection electrodes CNE1 and CNE2.

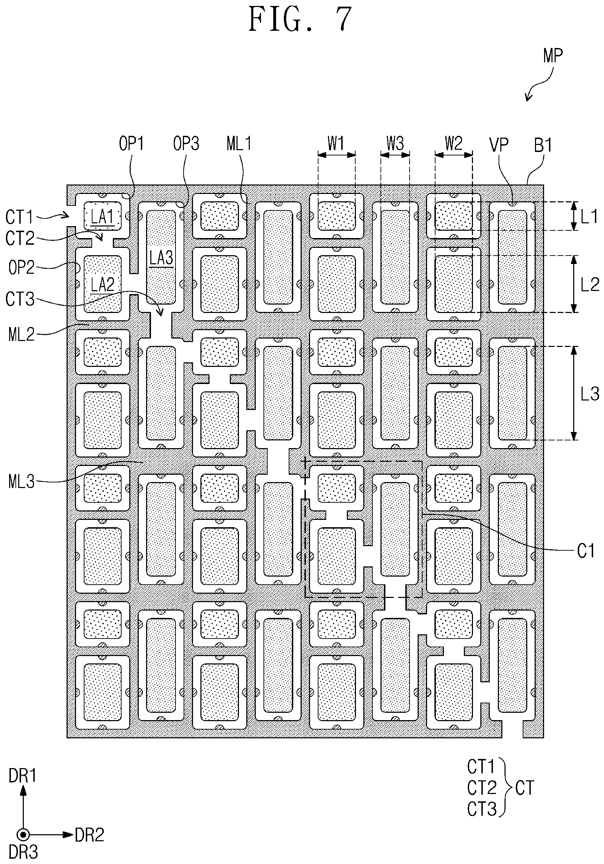

The pixel definition film PDL may be disposed on the sixth insulation layer INS6. In the pixel definition film PDL, a light emitting opening PX_OP which exposes a portion of the first electrode AE may be provided. The portion of the first electrode AE exposed by the light emitting opening PX_OP may be referred to as a light emitting region LA. The light emitting region LA may correspond to one of first, second and third light emitting regions LA1, LA2, and LA3 (see FIG. 7) to be described later.

A region in which the pixel definition film PDL is disposed may correspond to a non-light emitting region NLA. The non-light emitting region NLA may surround the light emitting region LA in the display region DA.

The hole control layer HCL may be disposed on the first electrode AE and the pixel definition film PDL. The hole control layer HCL may be provided as a common layer overlapping the light emitting region LA and the non-light emitting region NLA. The hole control layer HCL may include at least one of a hole transport layer, a hole injection layer, or an electron blocking layer.

The light emitting layer EML may be disposed on the hole control layer HCL. The light emitting layer EML may be disposed in a region corresponding to the light emitting opening PX_OP. However, the embodiment of the inventive concept is not necessarily limited thereto, and the light emitting layer EML may be provided as a common layer. The light emitting layer EML may include an organic material and/or an inorganic material. The light emitting layer EML may emit light of any one of red, green, or blue color.

The electron control layer ECL may be disposed on the light emitting layer EML. The electron control layer ECL may be provided as a common layer overlapping the light emitting region LA and the non-light emitting region NLA. The electron control layer ECL may include at least one of an electron transport layer, an electron injection layer, or a hole blocking layer.

The second electrode CE may be disposed on the electron control layer ECL. The second electrode CE may be provided as a common layer overlapping the light emitting region LA and the non-light emitting region NLA. The second electrode CE may be commonly disposed in the pixels PX (see FIG. 3) to apply a voltage to the pixels PX (see FIG. 3).

The thin film encapsulation layer TFE may be disposed on the second electrode CE to cover the light emitting element OLED. The thin film encapsulation layer TFE may include a plurality of thin films. For example, the thin film encapsulation layer TFE may include inorganic films disposed on the second electrode CE and an organic film disposed between the inorganic films. The inorganic film of the thin film encapsulation layer TFE may protect the light emitting element OLED from moisture/oxygen, and the organic film of the thin film encapsulation layer TFE may protect the light emitting element OLED from foreign substances such as dust particles. However, the embodiment of the thin film encapsulation layer TFE is not necessarily limited thereto.

A first voltage may be applied to the first electrode AE through the transistor TR, and a second voltage having a lower level than the first voltage may be applied to the second electrode CE. A hole and an electron injected into the light emitting layer EML are combined to form an exciton, and when the exciton transits to a ground state, the light emitting element OLED may emit light.

The input sensing layer ISP may include a first sensing insulation layer IL1, a second sensing insulation layer IL2, and a third sensing insulation layer IL3. The input sensing layer ISP may include at least one conductive layer disposed on the sensing insulation layers. The input sensing layer ISP may include a first conductive layer CDL1, and a second conductive layer CDL2.

The first sensing insulation layer IL1 may be disposed on the thin film encapsulation layer TFE. The first sensing insulation layer IL1 may include at least one inorganic insulation layer. The first sensing insulation layer IL1 may be in contact with the thin film encapsulation layer TFE. However, the embodiment of the inventive concept is not limited thereto, and in an embodiment, the first sensing insulation layer IL1 may be omitted, in which case the first conductive layer CDL1 may be in contact on the thin film encapsulation layer TFE.

The first conductive layer CDL1 may be disposed on the first sensing insulation layer IL1. The first conductive layer CDL1 may include a plurality of first conductive patterns. The plurality of first conductive patterns may be disposed on the first sensing insulation layer IL1.

The second insulation layer IL2 may be disposed on the first insulation layer IL1 to cover first sub-conductive patterns of the first conductive layer CDL1.

The second conductive layer CDL2 may be disposed on the second sensing insulation layer IL2. The second conductive layer CDL2 may contact the first conductive layer CDL1. The second conductive layer CDL2 may include a plurality of second conductive patterns. The plurality of second conductive patterns of the second conductive layer CDL2 may be disposed on the second sensing insulation layer IL2. The plurality of second conductive patterns may be respectively connected to the plurality of first conductive patterns of the first conductive layer CDL1 through contact holes formed in the second sensing insulation layer IL2.

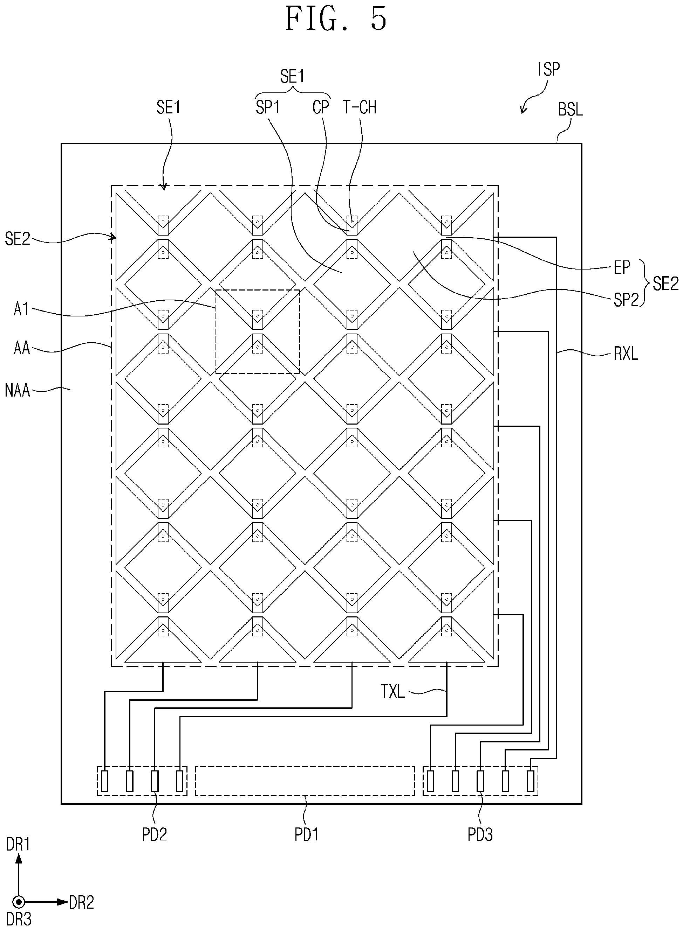

The plurality of first conductive patterns of the first conductive layer CDL1 and the plurality of second conductive patterns of the second conductive layer CDL2 may each be disposed to correspond to the non-light emitting region NLA. In other words, the plurality of first conductive patterns of the first conductive layer CDL1 and the plurality of second conductive patterns of the second conductive layer CDL2 may be provided in the non-light emitting region NLA. The plurality of first conductive patterns of the first conductive layer CDL1 and the plurality of second conductive patterns of the second conductive layer CDL2 may each correspond to a mesh pattern MP to be described later. The plurality of first conductive patterns of the first conductive layer CDL1 and the plurality of second conductive patterns of the second conductive layer CDL2 may respectively include a plurality of sensing units SP1 and SP2 (see FIG. 5) to be described later.

The third sensing insulation layer IL3 may be disposed on the second sensing insulation layer IL2, and may cover the second conductive layer CDL2. The second sensing insulation layer IL2 and the third sensing insulation layer IL3 may include an inorganic insulation layer or an organic insulation layer.

FIG. 5 is a plan view of the input sensing layer ISP according to an embodiment of the inventive concept.

The input sensing layer ISP may be disposed on the display panel DP (see FIG. 3). The input sensing layer ISP may be directly formed on the base surface provided by the display panel DP (see FIG. 3). In an embodiment, the input sensing layer ISP may be driven using a mutual-cap type technique. However, the embodiment of the inventive concept is not limited thereto, and the input sensing layer ISP may be driven using a self-cap type technique.

The input sensing layer ISP may include the first sensing insulation layer IL1, first sensing electrodes SE1, second sensing electrodes SE2, first sensing lines TXL, second sensing lines RXL, second pads PD2, and third pads PD3.

The first sensing insulation layer IL1 may provide a base surface on which the electrodes and lines of the input sensing layer ISP are disposed. In an embodiment, the first sensing insulation layer IL1 may be directly disposed on the thin film encapsulation layer TFE (see FIG. 4) of the display panel DP (see FIG. 4). However, the embodiment of the inventive concept is not limited thereto, and the first sensing insulation layer IL1 may be omitted, and the electrodes and lines of the input sensing layer ISP may be directly disposed on the thin film encapsulation layer TFE (see FIG. 4).

The first sensing insulation layer IL1 may include an active region AA and a peripheral region NAA. The active region AA may overlap the display region DA (see FIG. 3), and the peripheral region NAA may overlap the non-display region NDA (see FIG. 3).

Each of the first sensing electrodes SE1 is extended in the first direction DR1, and the first sensing electrodes SE1 may be arranged in the second direction DR2. FIG. 5 illustrates four first sensing electrodes SE1, but the number of first sensing electrodes SE1 included in the input sensing layer ISP is not limited thereto. Each of the first sensing electrodes SE1 may include first sensing units SP1 and connection patterns CP for connecting the first sensing units SP1.

The first sensing units SP1 may be arranged along the first direction DR1. Each of the connection patterns CP may be disposed between adjacent first sensing units SP1 in the first direction DR1 to electrically connect the adjacent first sensing units SP1. Each of the connection patterns CP may be extended in the first direction DR1. The connection patterns CP may overlap the first sensing units SP1 adjacent to the first direction DR1 on a plane. However, the shape of the connection patterns CP is not limited to any one embodiment as long as it allows adjacent first sensing units SP1 to be electrically connected.

The connection patterns CP may be disposed on a layer different from that of the first sensing units SP1. The connection patterns CP may be connected to corresponding first sensing units SP1 through contact holes T-CH. The contact holes T-CH may be formed by passing through an insulation layer disposed between the connection patterns CP and the first sensing units SP1.

Each of the second sensing electrodes SE2 is extended in the second direction DR2, and the second sensing electrodes SE2 may be arranged in the first direction DR1. FIG. 5 illustrates five second sensing electrodes SE2, but the number of second sensing electrodes SE2 included in the input sensing layer ISP is not limited thereto. Each of the second sensing electrodes SE2 may include second sensing units SP2 and extension patterns EP for connecting the second sensing units SP2.

The second sensing units SP2 may be arranged along the second direction DR2. Each of the extension patterns EP may be disposed between adjacent second sensing units SP2 in the second direction DR2 to electrically connect the adjacent second sensing units SP2.

Each of the extension patterns EP may be extended in the second direction DR2. The extension patterns EP may be insulated from the connection patterns CP and may intersect the connection patterns CP on a plane. The extension patterns EP may be extended from corresponding second sensing units SP2. In other words, the extension patterns EP may have a shape of a single body with the second sensing units SP2 on the same layer.

The first sensing electrodes SE1 and the second sensing electrodes SE2 are electrically insulated from each other, and may intersect each other on a plane. The input sensing layer ISP may sense an external input through a change in capacitance between the first sensing electrodes SE1 and the second sensing electrodes SE2. The first sensing electrodes SE1 and the second sensing electrodes SE2 may be disposed in the active region AA overlapping the display region DA (see FIG. 3). Accordingly, the display device DD (see FIG. 1) may simultaneously display an image through the display region DA (see FIG. 1) and sense an external input applied to the display region DA (see FIG. 1).

The first sensing lines TXL may be disposed on the peripheral region NAA and be electrically connected to the first sensing electrodes SE1, respectively. For example, the first sensing lines TXL may be electrically connected to lower ends of the first sensing electrodes SE1, respectively. The first sensing lines TXL may be disposed adjacent to a lower portion of the peripheral region NAA on the plane. The first sensing lines TXL may be respectively extended from the lower ends of the first sensing electrodes SE1 toward the second pads PD2.

The first sensing lines TXL may be electrically connected to the second pads PD2, respectively. The first sensing lines TXL may be disposed on a layer different from that of the second pads PD2 and be connected through contact holes, or may have a shape of a single body with the second pads PD2.

The second sensing lines RXL may be disposed on the peripheral region NAA and be electrically connected to the second sensing electrodes SE2, respectively. For example, the second sensing lines RXL may be electrically connected to right ends of the second sensing electrodes SE2, respectively. The second sensing lines RXL may be disposed adjacent to the right side of the peripheral region NAA on the plane. However, the embodiment of the inventive concept is not limited thereto, and the second sensing lines RXL may be disposed adjacent to the left side of the peripheral region NAA, or the second sensing lines RXL may be disposed divided on the left side and the right side of the peripheral region NAA. The second sensing lines RXL may be respectively extended from the right ends of the second sensing electrodes SE2 toward the third pads PD3.

The second sensing lines RXL may be electrically connected to the third pads PD3, respectively. The second sensing lines RXL may be disposed on a layer different from that of the third pads PD3 and be connected through contact holes, or may have a shape of a single body with the third pads PD3.

A touch controller for controlling the input sensing layer ISP may be electrically connected to the second pads PD2 and the third pads PD3 through a circuit board. The second pads PD2 and the third pads PD3 may be disposed along the second direction DR2. The second pads PD2 may be disposed adjacent to a lower left end of the peripheral region NAA on a plane, and the third pads PD3 may be disposed adjacent to a lower right end of the peripheral region on a plane.

The first pads PD1 of the display panel DP (see FIG. 3) may be disposed between the second pads PD2 and the third pads PD3. The second pads PD2 and the third pads PD3 may be disposed on the same layer with the first pads PD1. However, the embodiment of the inventive concept is not limited thereto, and the second pads PD2 and the third pads PD3 may be disposed on a layer different from that of the first pads PD1. The disposition of the pads PD1, PD2, and PD3 illustrated in FIG. 3 and FIG. 5 is merely an example, and the embodiment of the inventive concept is not limited thereto.

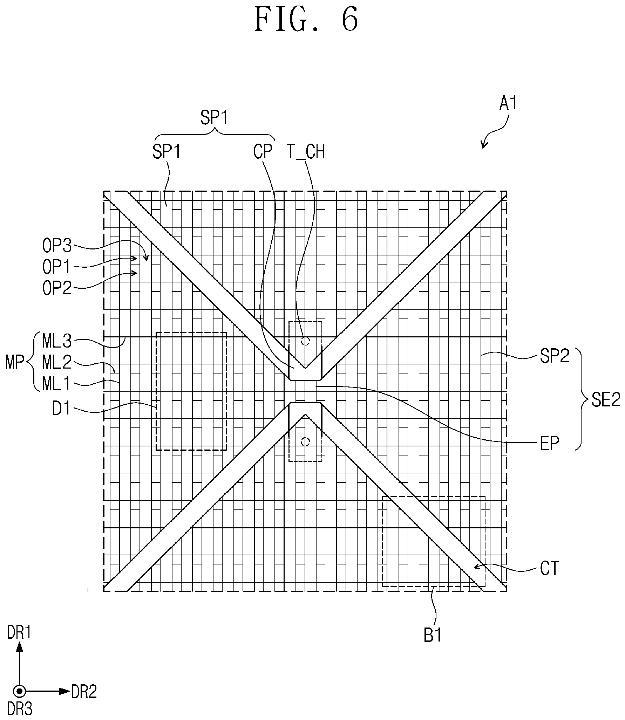

FIG. 6 is an enlarged view of a sensing unit according to an embodiment of the inventive concept. FIG. 6 illustrates an enlarged view of region A1 illustrated in FIG. 5. In other words, FIG. 6 illustrates an enlarged view of two first sensing units SP1 and two second sensing units SP2 of the input sensing layer ISP (see FIG. 5), and a connection portion thereof by the extension pattern EP and the connection pattern CP.

Referring to FIG. 6, the first sensing unit SP1 and the second sensing unit SP2 may each include a mesh pattern MP. The mesh pattern MP may include a conductive material. The mesh pattern MP may include mesh lines ML1, ML2, and ML3 which define at least two different openings OP1, OP2, and OP3. The openings OP1, OP2, and OP3 may be surrounded by the mesh lines ML1, ML2, and ML3.

The mesh lines ML1, ML2, and ML3 may include first mesh lines ML1, second mesh lines ML2, and third mesh lines ML3. The first mesh lines ML1, the second mesh lines ML2, and the third mesh lines ML3 may be connected to each other to have a shape of a single body.

Each of the first mesh lines ML1 may be extended in the first direction DR1, and the first mesh lines ML1 may be arranged in the second direction DR2. Each of the second mesh lines ML2 may be extended in the second direction DR2, and the second mesh lines ML2 may be arranged in the first direction DR1. The second mesh lines ML2 and the first mesh lines ML1 may intersect each other on a plane and have a shape of a single body. Each of the third mesh lines ML3 may be extended in the second direction DR2, and the third mesh lines ML3 may be arranged in the first direction DR1 and the second direction DR2. The third mesh lines ML3 may be alternately disposed with the second mesh lines ML2 in the first direction DR1. The third mesh lines ML3 may be spaced apart from each other with a third opening OP3 interposed therebetween in the second direction DR2.

The mesh pattern MP may include first to third openings OP1, OP2, and OP3 defined by the first to third mesh lines ML1, ML2, and ML3. The first to third openings OP1, OP2, and OP3 may differ in area on a plane. For example, the planar area of the third opening OP3 may be the largest of all the first to third openings OP1, OP2, and OP3, and the planar area of the first opening OP1 may be the smallest of all the first to third openings OP1, OP2, and OP3. Regions in which the first to third openings OP1, OP2, and OP3 are defined may be regions overlapping first to third light emitting regions LA1, LA2, and LA3 (see FIG. 7) to be described later. Since the first to third openings OP1, OP2, and OP3 are defined in the mesh pattern MP, each of the first sensing unit SP1 and the second sensing unit SP2 may not reduce luminous efficiency of the first to third light emitting regions LA1, LA2, and LA3 (see FIG. 7).

The first opening OP1 and the second opening OP2 may be respectively defined by being surrounded by the second mesh lines ML2 adjacent in the first direction DR1 and the first mesh lines ML1 adjacent in the second direction DR2. For example, two second mesh lines ML2 adjacent to each other in the first direction DR1 and two first mesh lines ML1 adjacent to each other in the second direction DR2 and in contact with the two adjacent second mesh lines ML2 form the first opening OP1 or the second opening OP2. The first opening OP1 and the second opening OP2 may be alternately formed along the first direction DR1. A common second mesh line ML2 among the second mesh lines ML2 may be disposed between the first opening OP1 and the second opening OP2. In other words, the first opening OP1 and the second opening OP2 may share the common second mesh line ML2 as a border. The first opening OP1 and the second opening OP2 may be respectively surrounded by the first mesh line ML1 and the second mesh line ML2.

The third opening OP3 may be surrounded by the third mesh lines ML3 adjacent in the first direction DR1 and the first mesh lines ML1 adjacent in the second direction DR2. For example, two third mesh lines ML3 adjacent to each other in the first direction DR1 and two first mesh lines ML1 adjacent to each other in the second direction DR2 and in contact with the two adjacent third mesh lines ML3 form the third opening OP3. The third openings OP3 may be disposed with a portion of a common third mesh line ML3 among the third mesh lines ML3 interposed therebetween in the first direction DR1. In other words, two adjacent third openings OP3 may share the common third mesh line ML3 as a border. The third opening OP3 may be surrounded by the first mesh line ML1 and the third mesh line ML3.

The first openings OP1 and the second openings OP2, and the third openings OP3 may be alternately formed along the second direction DR2. One third opening OP3 may overlap each of the first opening OP1 and the second opening OP2 in the second direction DR2.

The shape of the mesh pattern MP illustrated in FIG. 6 is merely an example, and the arrangement and shape of the first to third mesh lines ML1, ML2, and ML3 and the first to third openings OP1, OP2, and OP3 in the mesh pattern MP may vary depending on the arrangement and shape of the pixels PX (see FIG. 3) of the display panel DP (see FIG. 3).

In at least one of the first mesh lines ML1, the second mesh lines ML2, or the third mesh lines ML3 included in each of the first sensing unit SP1 and the second detector SP2, a cut portion may be provided. In an embodiment, the first sensing unit SP1 and the second sensing unit SP2 adjacent thereto are spaced apart from each other, and thus are electrically insulated from each other, and the cut portion may include a boundary cut portion CT located between the first sensing unit SP1 and the second sensing unit SP2. In the following description, the boundary cut portion CT is referred to as a "cut portion CT."

For convenience of description, FIG. 6 illustrates that the cut portion CT with a predetermined interval is provided between the first sensing unit SP1 and the second sensing unit SP2. However, the shape of the cut portion CT is not limited thereto, and the cut portion CT may have a shape in which a portion of each of the first mesh lines ML1, the second mesh lines ML2, and the third mesh lines ML3 is removed. The specific shape of the cut portion CT will be described later with reference to FIG. 7 and the like.

FIG. 7 is a plan view of a portion of a mesh pattern according to an embodiment of the inventive concept. FIG. 7 illustrates an enlarged view of region B1 illustrated in FIG. 6. For convenience of description, FIG. 7 also illustrates the light emitting regions LA1, LA2, and LA3 overlapping the mesh pattern MP.

Referring to FIG. 7, the mesh pattern MP may be a component of the first sensing units SP1 (see FIG. 5) or the second sensing units SP2 (see FIG. 5) described above. The mesh pattern MP may include first mesh lines ML1, second mesh lines ML2, and third mesh lines ML3. The above-described description may be applied to the first to third mesh lines ML1, ML2, and ML3.

The display panel DP (see FIG. 4) may include the light emitting regions LA1, LA2, and LA3. The display panel DP (see FIG. 4) may include the light emitting elements OLED (see FIG. 4), and each of the light emitting regions LA1, LA2, and LA3 may correspond to a region in which the light emitting elements OLED (see FIG. 4) are disposed. The light emitting regions LA1, LA2, and LA3 may include the first to third light emitting regions LA1, LA2, and LA3 separated according to the color of emitted light. The first to third light emitting regions LA1, LA2, and LA3 are regions in which first to third light emitting elements are disposed, respectively.

The first to third light emitting regions LA1, LA2, and LA3 may emit light of different colors from each other. For example, the first light emitting region LA1 may emit red light, the second light emitting region LA2 may emit green light, and the third light emitting region LA3 may emit blue light. However, colors of light emitted through the first to third light emitting regions LA1, LA2, and LA3 are not limited thereto.

Each of the first to third light emitting regions LA1, LA2, and LA3 may be provided in plural and be disposed in a predetermined arrangement on a plane. The first light emitting region LA1, the second light emitting region LA2, and the third light emitting region LA3 may be referred to as one pixel unit. The pixel unit including the first light emitting region LA1, the second light emitting region LA2, and the third light emitting region LA3 may be provided in plural and be arranged along the first direction DR1 and the second direction DR2.

The first light emitting regions LA1, the second light emitting regions LA2, and the third light emitting regions LA3 may be arranged along the first direction DR1 and the second direction DR2 on a plane. In the first direction DR1, the first light emitting regions LA1 and the second light emitting regions LA2 may be alternately arranged with each other. The third light emitting regions LA3 may be arranged along the first direction DR1, and may not overlap the first light emitting regions LA1 or the second light emitting regions LA2 in the first direction DR1. Each of the third light emitting regions LA3 may overlap with at least a portion of the first light emitting region LA1 and the second light emitting region LA2 in the second direction DR2. In the second direction DR2, the first light emitting regions LA1 and the third light emitting regions LA3 may be alternately arranged with each other, and in the second direction DR2, the second light emitting regions LA2 and the third light emitting regions LA3 may be alternately arranged with each other. However, the arrangement of the first to third light emitting regions LA1, LA2, and LA3 illustrated in FIG. 7 is merely an example, and the embodiment of the inventive concept is not limited thereto.

The first light emitting regions LA1 and the second light emitting regions LA2 arranged along the first direction DR1 may be referred to as a "first light emitting column," and the third light emitting regions LA3 arranged along the first direction DR1 may be referred to as a "second light emitting column." Each of the first light emitting column and the second light emitting column may be provided in plural, and be alternately arranged along the second direction DR2.

The first to third light emitting regions LA1, LA2, and LA3 may have various shapes on a plane. For example, the first to third light emitting regions LA1, LA2, and LA3 may have a polygonal shape, such as a quadrangle or an octagon, a circular shape, or an elliptical shape. Each of the first to third light emitting regions LA1, LA2, and LA3 may have a rectangular shape with rounded corners. The shape of each of the first to third light emitting regions LA1, LA2, and LA3 may correspond to the shape of the light emitting opening PX_OP (see FIG. 4) of the pixel definition film PDL (see FIG. 4).

The first to third light emitting regions LA1, LA2, and LA3 may have a predetermined area on a plane. For example, the first to third light emitting regions LA1, LA2, and LA3 may differ in area on a plane. However, the embodiment of the inventive concept is not limited thereto, and the first to third light emitting regions LA1, LA2, and LA3 may differ in length and width from each other, but may have substantially the same area. The area of the first to third light emitting regions LA1, LA2, and LA3 may be variously designed according to the color of emitted light, luminous efficiency, resolution, size of the display device DD (see FIG. 1), and the like.

The first to third mesh lines ML1, ML2, and ML3 may not overlap the first to third light emitting regions LA1, LA2, and LA3. The first to third mesh lines ML1, ML2, and ML3 may overlap the non-light emitting region NLA (see FIG. 4). The first to third openings OP1, OP2, and OP3 defined by the first to third mesh lines ML1, ML2, and ML3 may respectively overlap the first to third light emitting regions LA1, LA2, and LA3.

Each of the first to third openings OP1, OP2, and OP3 may have a planar area larger than the area of an overlapping light emitting region. For example, the planar area of the first opening OP1 may be larger than the area of the first light emitting region LA1, the planar area of the second opening OP2 may be larger than the area of the second light emitting region LA2, and the planar area of the third opening OP3 may be larger than the area of the third light emitting region LA3. As a result, the mesh pattern MP may not reduce the luminous efficiency of light emitted through the first to third light emitting regions LA1, LA2, and LA3.

The first mesh lines ML1 may be extended in the first direction DR1, and may be arranged along the second direction DR2. The first mesh lines ML1 may be disposed between the first light emitting regions LA1 and the second light emitting regions LA2 arranged along the first direction DR1 (e.g., the first light emitting column) and the third light emitting regions LA3 arranged along the first direction DR1 (e.g., the second light emitting column).

The second mesh lines ML2 may be extended in the second direction DR2, and may be arranged along the first direction DR1. The second mesh lines ML2 may have a shape of a single body with the first mesh lines ML1. In other words, the second mesh lines ML2 may have a shape of being extended from the first mesh lines ML1 in the second direction DR2. The second mesh lines ML2 may be disposed between the first light emitting region LA1 and the second light emitting region LA2 facing each other in the first direction DR1. In other words, the second mesh lines ML2 may be disposed between the first light emitting region LA1 and the second light emitting region LA2 adjacent to each other in the first direction DR1.

The third mesh lines ML3 may be extended in the second direction DR2, and may be arranged along the first direction DR1. The third mesh lines ML3 may have a shape of a single body with the first mesh lines ML1. The third mesh lines ML3 may have a shape of being extended from the first mesh lines ML1 in the second direction DR2. For example, the third mesh lines ML3 may be connected to the first mesh lines ML1 via the second mesh lines ML2. The third mesh lines ML3 may be disposed between two adjacent third light emitting regions LA3. In the first direction DR1, the third mesh lines ML3 may be disposed with the third light emitting region LA3 interposed therebetween.

The second mesh line ML2 and the third mesh line ML3 may have different line widths from each other. For example, the second mesh line ML2 disposed between the first light emitting region LA1 and the second light emitting region LA2 may have a first line width, and the third mesh line ML3 disposed between the third light emitting regions LA3 may have a second line width. The second line width may be greater than the first line width. This may vary depending on the area of the first to third light emitting regions LA1, LA2, and LA3 and intervals between the first to third light emitting regions LA1, LA2, and LA3. The embodiment of the inventive concept is not limited thereto, and the first line width and the second line width may be substantially the same.

The disposition and shape of the first to third mesh lines ML1, ML2, and ML3 may be changed in various ways depending on the disposition and planar area of the first to third openings OP1, OP2, and OP3 defined in the mesh pattern MP. In addition, the disposition and planar area of the first to third openings OP1, OP2, and OP3 may be changed in various ways depending on the disposition and area of corresponding first to third light emitting regions LA1, LA2, and LA3.

It is to be understood that for convenience of description, the first to third mesh lines ML1, ML2, and ML3 have been described separately, but the first to third mesh lines ML1, ML2, and ML3 may be connected to each other and have a shape of a single body. In other words, the first to third mesh lines ML1, ML2, and ML3 may be formed by patterning the first to third openings OP1, OP2, and OP3 on an integral conductive layer.

Each of the first to third light emitting regions LA1, LA2, and LA3 may have a predetermined length in the first direction DR1, and a predetermined width in the second direction DR2. The first light emitting region LA1 may have a first length L1 in the first direction DR1, and may have a first width W1 in the second direction DR2. The second light emitting region LA2 may have a second length L2 in the first direction DR1, and may have a second width W2 in the second direction DR2. The third light emitting region LA3 may have a third length L3 in the first direction DR1, and may have a third width W3 in the second direction DR2.

The first to third lengths L1, L2, and L3 of the first to third light emitting regions LA1, LA2, and LA3 in the first direction DR1 may be different from each other. For example, the length may increase in the order of the first length L1, the second length L2, and the third length L3.

In the second direction DR2, the first to third widths W1, W2, and W3 of the first to third light emitting regions LA1, LA2, and LA3 may be different from each other. For example, the width may increase in the order of the third width W3, the second width W2, and the first width W1. However, the embodiment of the inventive concept is not limited thereto, and the first width W1 and the second width W2 may be substantially the same. Compared to the size difference between the first to third lengths L1, L2, and L3, the size difference between the first to third widths W1, W2, and W3 may not be large.

Referring to FIG. 6 and FIG. 7 together, in at least a portion of the first to third mesh lines ML1, ML2, and ML3 of the mesh pattern MP, the cut portion CT may be provided. As described above, the cut portion CT may correspond to a boundary cut portion formed between the first sensing unit SP1 and the second sensing unit SP2. In other words, based on the cut portion CT, a mesh pattern MP included in the first sensing unit SP1 and a mesh pattern MP included in the second sensing unit SP2 may be separated.

Additionally, the mesh pattern MP included in each of the first sensing unit SP1 and the second sensing unit SP2 includes a plurality of visual patterns VP disposed on one side of the first to third mesh lines ML1, ML2, and ML3. Each of the plurality of visual patterns VP may have a shape of either protruding from any one of the first to third mesh lines ML1, ML2, and ML3 in a direction closer to each of the first to third light emitting regions LA1, LA2, and LA3, or a shape of being recessed in a direction farther away therefrom. The disposition and shape of the plurality of visual patterns VP will be described later.

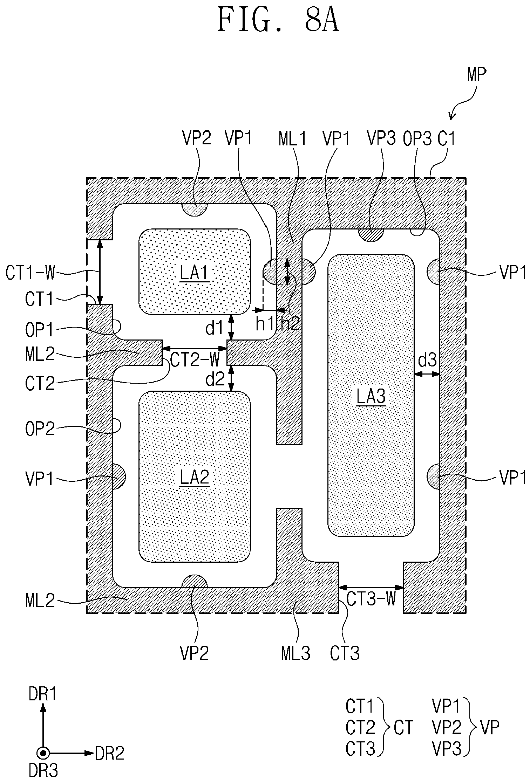

FIG. 8A is a plan view of a portion of a mesh pattern according to an embodiment of the inventive concept. FIG. 8A illustrates an enlarged view of region C1 illustrated in FIG. 7. For convenience of description, FIG. 8A also illustrates the first to third light emitting regions LA1, LA2, and LA3 overlapping the mesh pattern MP.

Referring to FIG. 7 and FIG. 8A together, the mesh pattern MP may include the first mesh lines ML1, the second mesh lines ML2, and the third mesh lines ML3. The above-described description may be applied to the first to third mesh lines ML1, ML2, and ML3.

The first to third mesh lines ML1, ML2, and ML3 may not overlap the first to third light emitting regions LA1, LA2, and LA3. The first to third mesh lines ML1, ML2, and ML3 may overlap the non-light emitting region NLA (see FIG. 4). The first to third openings OP1, OP2, and OP3 defined by the first to third mesh lines ML1, ML2, and ML3 may respectively overlap the first to third light emitting regions LA1, LA2, and LA3.

Each of the first to third openings OP1, OP2, and OP3 may have a planar area larger than the area of an overlapping light emitting region. For example, the planar area of the first opening OP1 may be larger than the area of the first light emitting region LA1, the planar area of the second opening OP2 may be larger than the area of the second light emitting region LA2, and the planar area of the third opening OP3 may be larger than the area of the third light emitting region LA3. As a result, the mesh pattern MP may not reduce the luminous efficiency of light emitted through the light emitting regions LA1, LA2, and LA3.

In at least a portion of the first to third mesh lines ML1, ML2, and ML3 of the mesh pattern MP, the cut portion CT may be provided.

The cut portions CT may have a shape of a single body with adjacent openings among the first to third openings OP1, OP2, and OP3. In other words, the cut portions CT may be connected to the adjacent openings to form a single space. For example, each of the cut portions CT may be provided in at least a portion of the first to third mesh lines ML1, ML2, and ML3, and may have a shape of a single body with adjacent first to third openings OP1, OP2, and OP3. In the mesh pattern MP of an embodiment, a first cut portion CT1 may be provided in the first mesh line ML1, a second cut portion CT2 may be provided in the second mesh line ML2, and a third cut portion CT3 may be provided in the third mesh line ML3.

Each of the cut portions CT may have a predetermined width. In an embodiment, the first cut portion CT1 may have a first width CT1-W, the second cut portion CT2 may have a second width CT2-W, and the third cut portion CT3 may have a third width CT3-W. The first width CT1-W of the first cut portion CT1, the second width CT2-W of the second cut portion CT2, and the third width CT3-W of the third cut portion CT3 may each be about 2.5 micrometers to about 7 micrometers.

The mesh pattern MP includes a plurality of visual patterns VP disposed on one side of the first to third mesh lines ML1, ML2, and ML3. Each of the plurality of visual patterns VP may have a shape of either protruding from any one of first to third the mesh lines ML1, ML2, and ML3 in a direction closer to each of the first to third light emitting regions LA1, LA2, and LA3, or a shape of being recessed in a direction farther away therefrom. For example, as illustrated in FIG. 8A, each of the plurality of visual patterns VP may have a shape of protruding from the first to third mesh lines ML1, ML2, and ML3 in a direction to be closer to each of the first to third light emitting regions LA1, LA2, and LA3, respectively. FIG. 8A illustrates that the plurality of visual patterns VP have a shape distinct from that of the first to third mesh lines ML1, ML2, and ML3, but the embodiment of the inventive concept is not limited thereto, and the plurality of visual patterns VP may have a shape of a single body with the first to third mesh lines ML1, ML2, and ML3. The plurality of visual patterns VP may be formed as one layer with the first to third mesh lines ML1, ML2, and ML3 through the same process, and then formed by removing the remaining portion. The plurality of visual patterns VP may include the same material as that of the first to third mesh lines ML1, ML2, and ML3.

The plurality of visual patterns VP may include a first visual pattern VP1 disposed on one side of the first mesh lines ML1, a second visual pattern VP2 disposed on one side of the second mesh lines ML2, and a third visual pattern VP3 disposed on one side of the third mesh lines ML3. Each of the first visual pattern VP1, the second visual pattern VP2, and the third visual pattern VP3 may have a shape of protruding from the first to third mesh lines ML1, ML2, and ML3 in a direction to be closer to each of the first to third light emitting regions LA1, LA2, and LA3. The first visual pattern VP1 may have a shape of protruding in the second direction DR2 from the first mesh line ML1 extended in the first direction DR1, the second visual pattern VP2 may have a shape of protruding in the first direction DR1 from the second mesh line ML2 extended in the second direction DR2, and the third visual pattern VP3 may have a shape of protruding in the first direction DR1 from the third mesh line ML3 extended in the second direction DR2. Additionally, the first visual pattern VP1 may protrude in a direction opposite the second direction DR2 from the first mesh line ML1 extended in the first direction DR1, the second visual pattern VP2 may protrude in a direction opposite the first direction DR1 from the second mesh line ML2 extended in the second direction DR2, and the third visual pattern VP3 may protrude in a direction opposite the first direction DR1 from the third mesh line ML3 extended in the second direction DR2.

In the mesh pattern MP of an embodiment, at least one of the plurality of visual patterns VP is disposed to overlap the aforementioned cut portion CT in one direction. For example, as illustrated in FIG. 8A, any one of the first visual patterns VP1 disposed on one side of the first mesh lines ML1 may overlap the first cut portion CT1 in the second direction DR1, any one of the second visual patterns VP2 disposed on one side of the second mesh lines ML2 may overlap the second cut portion CT2 in the first direction DR1, and any one of the third visual patterns VP3 disposed on one side of the third mesh lines ML3 may overlap the third cut portion CT3 in the first direction DR1.

Referring to FIG. 7 and FIG. 8A together, at least one visual pattern VP may be disposed in each of the mesh lines surrounding each of the first to third light emitting regions LA1, LA2, and LA3. In the mesh lines surrounding each of the first to third light emitting regions LA1, LA2, and LA3, the cut portion CT may be provided on one side on which the visual pattern VP is not disposed. For example, as illustrated in FIG. 8A, two cut portions may be provided and two visual patterns may be disposed in mesh lines defining the first opening OP1 surrounding the first light emitting region LA1. Two cut portions may be provided and two visual patterns may be disposed in mesh lines defining the second opening OP2 surrounding the second light emitting region LA2. Two cut portions may be provided and four visual patterns may be disposed in mesh lines defining the third opening OP3 surrounding the third light emitting region LA3. Visual patterns disposed in the mesh lines defining the first opening OP1 surrounding the first light emitting region LA1 may be referred to as a "first group visual pattern." Visual patterns disposed in the mesh lines defining the second opening OP2 surrounding the second light emitting region LA2 may be referred to as a "second group visual pattern." Visual patterns disposed in the mesh lines defining the third opening OP3 surrounding the third light emitting region LA3 may be referred to as a "third group visual pattern."

Each of the plurality of visual patterns VP may protrude from each of the first to third mesh lines ML1, ML2, and ML3 by a predetermined height h1. In an embodiment, each of the first visual pattern VP1, the second visual pattern VP2, and the third visual pattern VP3 may protrude from the mesh lines ML1, ML2, and ML3 by the predetermined height h1, and the protrusion height h1 may be about 1 micrometer to about 5 micrometers. For example, the height h1 by which the plurality of visual patterns VP protrude from the first to third mesh lines ML1, ML2, and ML3 may be about 1 micrometer to about 2 micrometers. When the protrusion height h1 of each of the plurality of visual patterns VP is less than about 1 micrometer, it may be difficult to implement the visibility improvement effect to be described later. When the protrusion height h1 of each of the plurality of visual patterns VP is greater than about 5 micrometers, the first to third light emitting regions LA1, LA2, and LA3 may be partially covered due to the visual pattern VP, which may result in degradation in display efficiency.

The height h1 by which each of the plurality of visual patterns VP protrudes from each of the first to third mesh lines ML1, ML2, and ML3 may be small compared to intervals between the first to third mesh lines ML1, ML2, and ML3 and the first to third light emitting regions LA1, LA2, and LA3. In an embodiment, the first light emitting region LA1 is spaced apart from the first to third mesh lines ML1, ML2, and ML3 by a first interval d1, the second light emitting region LA2 is spaced apart from the first to third mesh lines ML1, ML2, and ML3 by a second interval d2, and the third light emitting region LA3 is spaced apart from the first to third mesh lines ML1, ML2, and ML3 by a third interval d3, and the protrusion height h1 of each of the plurality of visual patterns VP may be less than the first interval d1, the second interval d2, and the third interval d3.

Each of the plurality of visual patterns VP may have a predetermined width h2. In an embodiment, the width h2 of each of the plurality of visual patterns VP may be about 2.5 micrometers to about 7 micrometers.

A plurality of sensing units included in an input sensing layer of an embodiment include a mesh pattern, and the mesh pattern includes a plurality of visual patterns disposed on one side of mesh lines. The plurality of visual patterns are disposed to be adjacent to each of a plurality of light emitting regions surrounded by the mesh lines, and at least one of the plurality of visual patterns may be disposed to overlap a cut portion provided in the mesh lines in one direction. Since the mesh pattern of an embodiment includes the plurality of visual patterns, a defect in which an area where the cut portion is formed is visually recognized from the outside may be prevented. Therefore, the visibility of the input sensing layer including the mesh pattern and the visibility of the display device may be improved.

Specifically, in the plurality of sensing units included in the input sensing layer, a boundary cut portion is provided to separate boundaries of a first sensing unit and a second sensing unit which have different extension directions. However, in an area where the cut portion is formed, the mesh pattern is omitted, so that the reflectance is lowered due to an area where the cut portion is not provided, and accordingly, the area where the cut portion is formed may be visually recognized from the outside. Since the plurality of visual patterns disposed to overlap the cut portion in one direction are included in the input sensing layer according to an embodiment of the inventive concept, the area where the cut portion is formed and an area where the plurality of visual patterns are disposed have similar non-reflection properties. Therefore, it is possible to prevent the defect in which the area where the cut portion is formed is visually recognized from the outside. Therefore, the visibility of the input sensing layer including the mesh pattern and the visibility of the display device may be improved.

Additionally, when a plurality of cut portions for improving visibility are formed in portions corresponding to the boundary cut portions to improve the visibility of the input sensing layer and the display device, the resistance of a metal mesh pattern may be excessively increased due to the plurality of cut portions provided in the mesh pattern. In the input sensing layer of an embodiment, instead of forming a cut portion for improving visibility in correspondence with a boundary cut portion, a plurality of visual patterns disposed on one side of mesh lines are formed, so that it is possible to prevent an excessive increase in resistance of a metal mesh pattern, thereby preventing degradation in touch sensing performance due to an increase in the resistance.

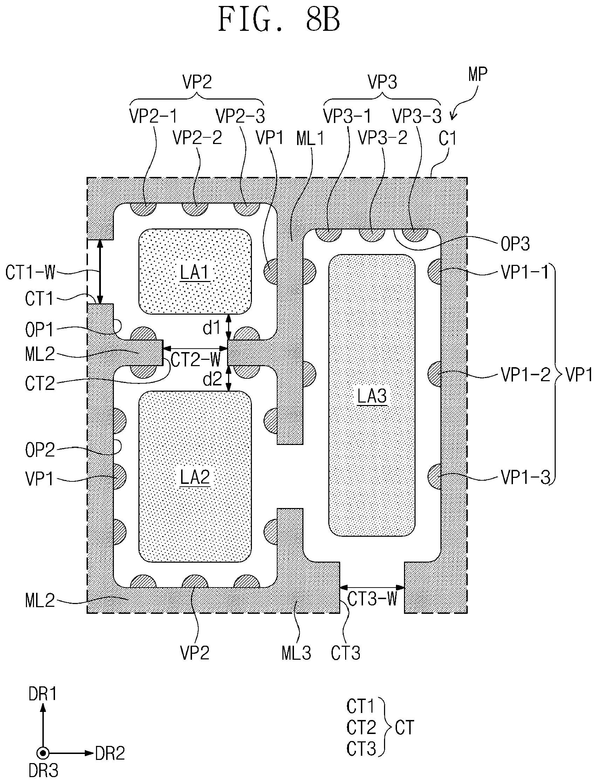

FIG. 8B to FIG. 8F are each a plan view of a portion of a mesh pattern according to an embodiment of the present invention. FIG. 8B to FIG. 8F each illustrate a plan view of a mesh pattern of an embodiment different from the mesh pattern of an embodiment illustrated in FIG. 8A.

Referring to FIG. 8A and FIG. 8B together, each of a plurality of visual patterns VP disposed on one side of first to third mesh lines ML1, ML2, and ML3 may be provided in plurality in corresponding ones of the first to third mesh lines ML1, ML2, and ML3. For example, as illustrated in FIG. 8B, a first visual pattern VP1 disposed in a first mesh line ML1 may include a 1-1 visual pattern VP1-1, a 1-2 visual pattern VP1-2, and a 1-3 visual pattern VP1-3, which are disposed side by side along the first direction DR1 in the corresponding first mesh line ML1. Each of the 1-1 visual pattern VP1-1, the 1-2 visual pattern VP1-2 and the 1-3 visual pattern VP1-3 may protrude from the same first mesh line ML1. A second visual pattern VP2 disposed in a second mesh line ML2 may include a 2-1 visual pattern VP2-1, a 2-2 visual pattern VP2-2, and a 2-3 visual pattern VP2-3, which are disposed side by side along the second direction DR2 in the corresponding second mesh line ML2. Each of the 2-1 visual pattern VP2-1, the 2-2 visual pattern VP2-2 and the 2-3 visual pattern VP2-3 may protrude from the same second mesh line ML2. A third visual pattern VP3 disposed in a third mesh line ML3 may include a 3-1 visual pattern VP3-1, a 3-2 visual pattern VP3-2, and a 3-3 visual pattern VP3-3, which are disposed side by side along the second direction DR2 in the corresponding third mesh line ML3. Each of the 3-1 visual pattern VP3-1, the 3-2 visual pattern VP3-2 and the 3-3 visual pattern VP3-3 may protrude from the same third mesh line ML3.

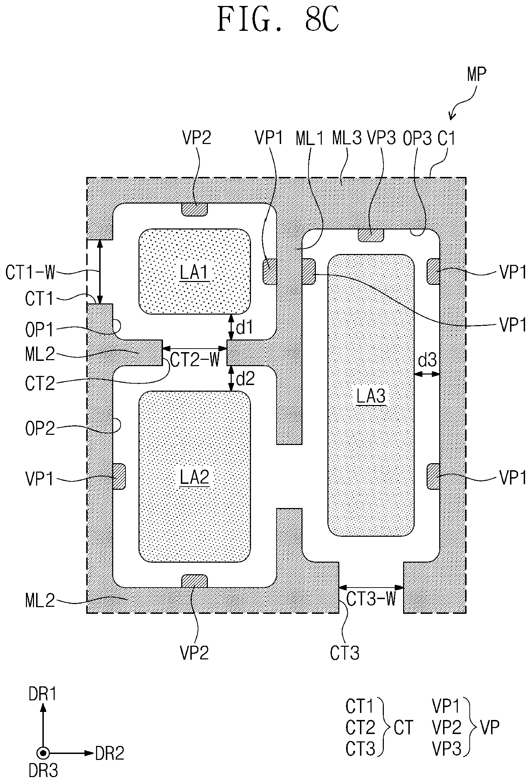

Referring to FIG. 8A and FIG. 8C together, at least a portion of each of the plurality of visual patterns VP disposed on one side of the first to third mesh lines ML1, ML2, and ML3 may have a round shape.

For example, as illustrated in FIG. 8A and FIG. 8B, each of the plurality of visual patterns VP may have a semi-circular shape on a plane. Alternatively, each of the plurality of visual patterns VP may have a semi-elliptical shape on a plane.

Alternatively, as illustrated in FIG. 8C, each of the plurality of visual patterns VP may have a rectangular shape with rounded corners on a plane. Since at least a partial surface of each of the plurality of visual patterns VP is designed to have a round shape, the effect of improving the visibility of the input sensing layer and the display device may be implemented by the plurality of visual patterns.

Additionally, in a process of forming each of the plurality of visual patterns VP, each of the plurality of visual patterns VP is designed to have a rectangular shape, but may be formed to have a partial surface with a rounded shape in an etching process.

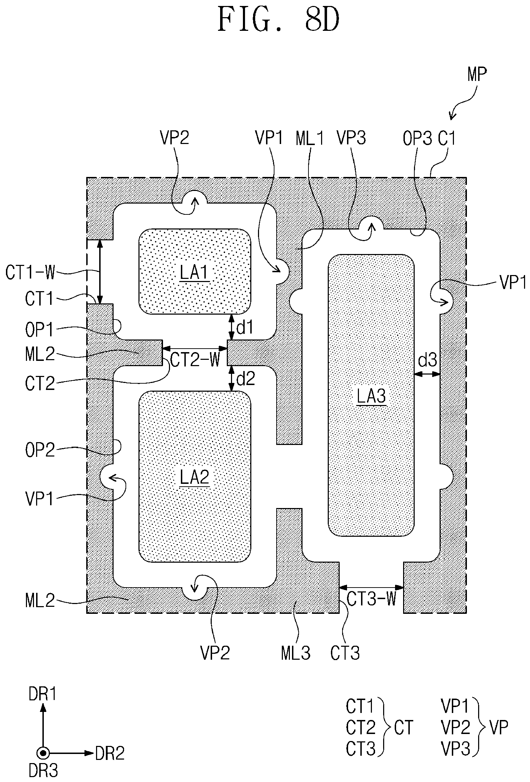

Referring to FIG. 8A and FIG. 8D together, each of the plurality of visual patterns VP may have a shape of either protruding from any one of the first to third mesh lines ML1, ML2, and ML3 in a direction closer to each of the first to third light emitting regions LA1, LA2, and LA3, or a shape of being recessed in a direction farther away therefrom. For example, as illustrated in FIG. 8A, each of the plurality of visual patterns VP may have a shape of protruding from the first to third mesh lines ML1, ML2, and ML3 in a direction closer to each of the first to third light emitting regions LA1, LA2, and LA3. Alternatively, as illustrated in FIG. 8D, each of the plurality of visual patterns VP may be recessed from the first to third mesh lines ML1, ML2, and ML3 in a direction farther away from each of the first to third light emitting regions LA1, LA2, and LA3. When each of the plurality of visual patterns VP has a shape of being recessed in the direction farther away from each of the first to third light emitting regions LA1, LA2, and LA3, a recessed depth may be smaller than the thickness of the first to third mesh lines ML1, ML2, and ML3. For example, the minimum width of the first to third mesh lines ML1, ML2, and ML3 may be about 3 micrometers, and the depth by which each of the plurality of visual patterns VP is recessed may be less than 3 micrometers.

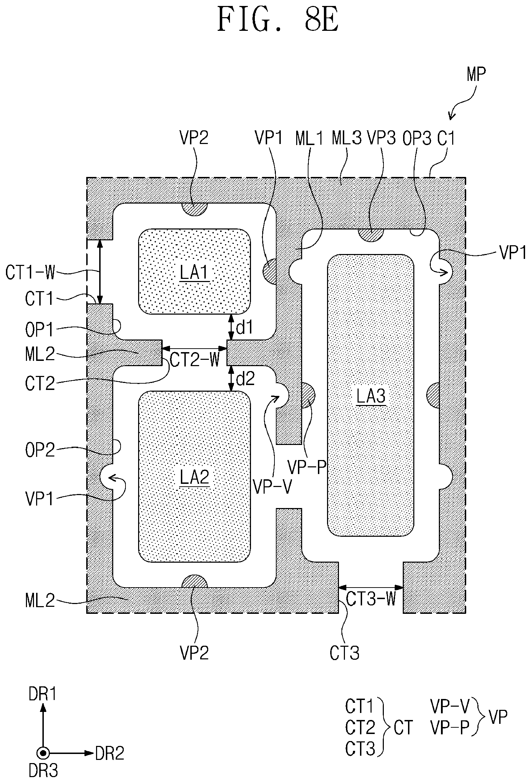

Referring to FIG. 8E, the plurality of visual patterns VP may include both a pattern protruding in a direction closer to each of the first to third light emitting regions LA1, LA2, and LA3 and a pattern recessed in a direction farther away from each of the first to third light emitting regions LA1, LA2, and LA3. As illustrated in FIG. 8E, each of the visual patterns VP may include a protruding visual pattern VP-P protruding from any one of the first to third mesh lines ML1, ML2, and ML3, and a recessed visual pattern VP-V recessed from any one of the first to third mesh lines ML1, ML2, and ML3. As illustrated in FIG. 8E, the protruding visual pattern VP-P and the recessed visual pattern VP-V may be disposed to correspond to each other with one mesh line, for example, the first mesh line ML1 interposed therebetween. In other words, the protruding visual pattern VP-P and the recessed visual pattern VP-V may be arranged along the same line.

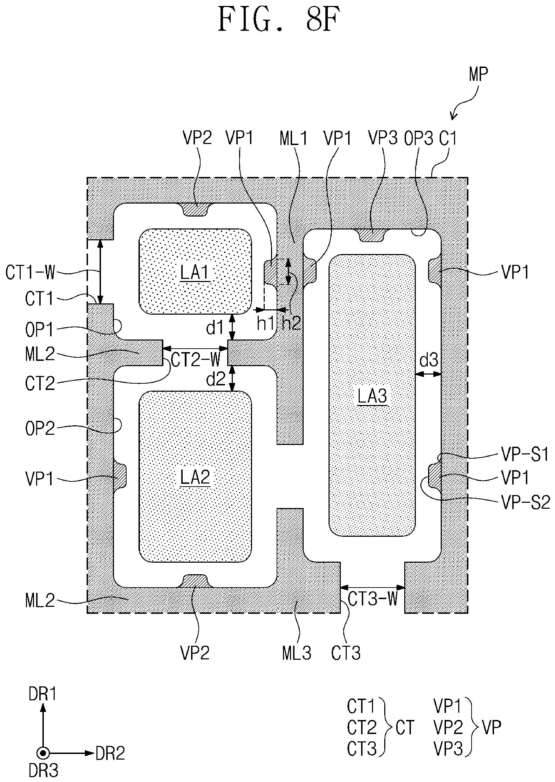

Referring to FIG. 8A, FIG. 8C, and FIG. 8F together, each of the plurality of visual patterns VP disposed on one side of the first to third mesh lines ML1, ML2, and ML3 may have at least a portion thereof with a round shape, and may have a shape with a decreasing width farther away from the first to third mesh lines ML1, ML2, and ML3.

As illustrated in FIG. 8F, each of the plurality of visual patterns VP may include a first visual surface VP-S1 and a second visual surface VP-S2. The first visual surface VP-S1 may be a surface extended from the first to third mesh lines ML1, ML2, and ML3, and the second visual surface VP-S2 may be a surface extended from the first visual surface VP-S1.

The first visual surface VP-S1 may include a sloped surface such that the width of each of the visual patterns VP decreases upward. The second visual surface VP-S2 may be extended from the first visual surface VP-S1, and may correspond to the uppermost surface of the visual pattern VP. The second visual surface VP-S2 may have a blunt shape at the end. For example, the second visual surface VP-S2 may be flat.

The first visual surface VP-S1 may have a first slope. The first slope of the first visual surface VP-S1 may change farther away from the first to third mesh lines ML1, ML2, and ML3. For example, the first visual surface VP-S1 may have a shape in which the first slope increases farther away from the first to third mesh lines ML1, ML2, and ML3. A portion of the second visual surface VP-S2 may have a second slope different from the first slope. The second slope of the second visual surface VP-S2 may be smaller than the first slope of the first visual surface VP-S1. Since the second slope of the second visual surface VP-S2 is smaller than the first slope of the first visual surface VP-S1, the second visual surface VP-S2 may have a blunt shape at the end.

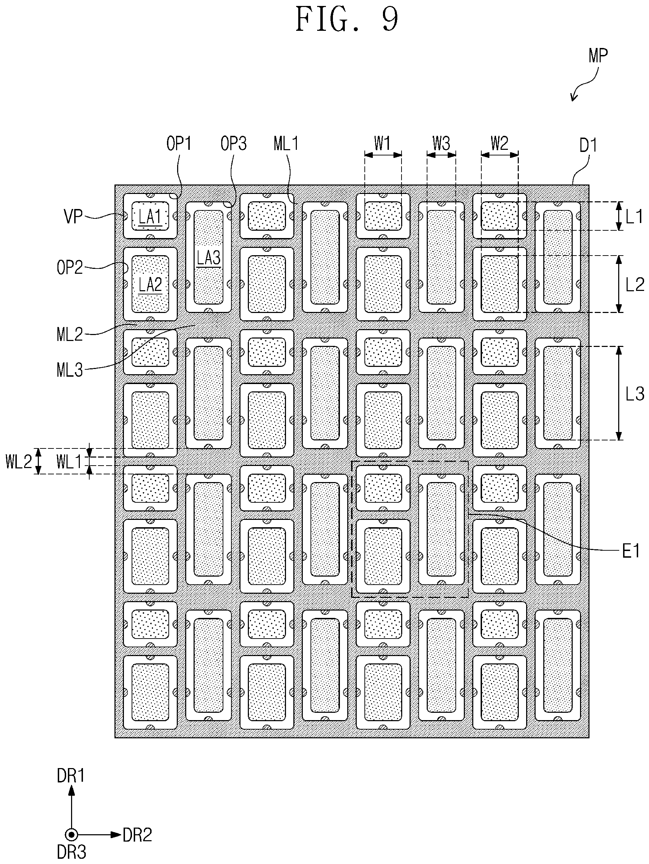

FIG. 9 is a plan view of a portion of a mesh pattern according to an embodiment of the inventive concept. FIG. 9 illustrates an enlarged view of region D1 illustrated in FIG. 6. For convenience of description, FIG. 9 also illustrates the first to third light emitting regions LA1, LA2, and LA3 overlapping the mesh pattern MP.

Referring to FIG. 6, FIG. 7, and FIG. 9 together, the mesh pattern MP may include a plurality of visual patterns VP disposed on one side of the first to third mesh lines ML1, ML2, and ML3 in the region D1, which is a portion of a sensing unit that does not correspond to the boundary cut portion CT, in addition to the region B1 of FIG. 7 in which the boundary cut portion CT is provided. As described above, each of the plurality of visual patterns VP may have a shape of either protruding from any one of the above described first to third mesh lines ML1, ML2, and ML3 in a direction closer to each of the first to third light emitting regions LA1, LA2, and LA3, or a shape of being recessed in a direction farther away therefrom. The mesh pattern MP portion illustrated in FIG. 9 corresponds to a portion that does not correspond to the boundary cut portion CT, and the plurality of visual patterns VP may be disposed in all of the first to third mesh lines ML1, ML2, and ML3 surrounding each of the first to third light emitting regions LA1, LA2, and LA3.

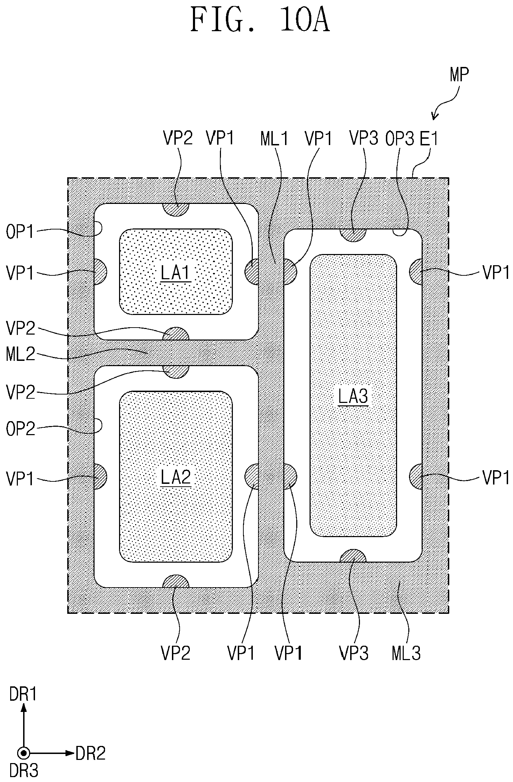

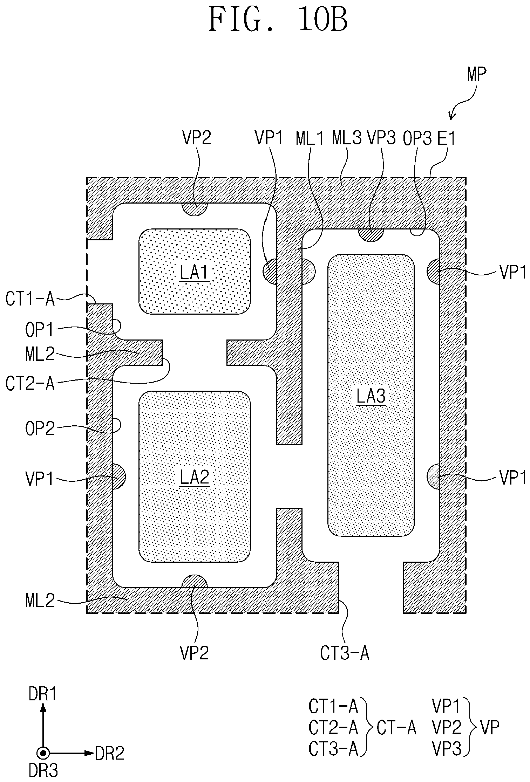

FIG. 10A and FIG. 10B are each a plan view of a portion of a mesh pattern according to an embodiment of the present invention. FIG. 10A and FIG. 10B each illustrate an enlarged view of region E1 illustrated in FIG. 9.

Referring to FIG. 9 and FIG. 10A together, the mesh pattern MP may include first mesh lines ML1, second mesh lines ML2, and third mesh lines ML3. The above-described description may be applied to the first to third mesh lines ML1, ML2, and ML3.

The mesh pattern MP includes a plurality of visual patterns VP disposed on one side of the first to third mesh lines ML1, ML2, and ML3. Each of the plurality of visual patterns VP may have a shape of either protruding from any one of the first to third mesh lines ML1, ML2, and ML3 in a direction closer to each of the first to third light emitting regions LA1, LA2, and LA3, or a shape of being recessed in a direction farther away therefrom.

The plurality of visual patterns VP may include a first visual pattern VP1 disposed on one side of the first mesh lines ML1, a second visual pattern VP2 disposed on one side of the second mesh lines ML2, and a third visual pattern VP3 disposed on one side of the third mesh lines ML3. Each of the first visual pattern VP1, the second visual pattern VP2, and the third visual pattern VP3 may have a shape of protruding from the first to third mesh lines ML1, ML2, and ML3 in a direction closer to each of the first to third light emitting regions LA1, LA2, and LA3. The first visual pattern VP1 may have a shape of protruding in the second direction DR2 from the first mesh line ML1 extended in the first direction DR1, the second visual pattern VP2 may have a shape of protruding in the first direction DR1 from the second mesh line ML2 extended in the second direction DR2, and the third visual pattern VP3 may have a shape of protruding in the first direction DR1 from the third mesh line ML3 extended in the second direction DR2.

Referring to FIG. 9 and FIG. 10A together, at least one visual pattern VP may be disposed in each of the mesh lines surrounding each of the first to third light emitting regions LA1, LA2, and LA3. In one region illustrated in FIG. 9 and FIG. 10A, a separate cut portion is not provided, and in mesh lines surrounding each of the first to third light emitting regions LA1, LA2, and LA3, a visual pattern VP may be disposed in each of four corner portions of the mesh lines. For example, as illustrated in FIG. 10A, a total of four visual patterns, one for each corner, may be disposed in mesh lines defining a first opening OP1 surrounding the first light emitting region LA1. A total of four visual patterns, one for each corner, may be disposed in mesh lines defining a second opening OP2 surrounding the second light emitting region LA2. A total of six visual patterns, one for two corners and two for the other two corners, may be disposed in mesh lines defining a third opening OP3 surrounding the third light emitting region LA3. Visual patterns disposed in the mesh lines defining the first opening OP1 surrounding the first light emitting region LA1 may be referred to as a "first group visual pattern." Visual patterns disposed in the mesh lines defining the second opening OP2 surrounding the second light emitting region LA2 may be referred to as a "second group visual pattern." Visual patterns disposed in the mesh lines defining the third opening OP3 surrounding the third light emitting region LA3 may be referred to as a "third group visual pattern."

Referring to FIG. 6, FIG. 7, FIG. 9, and FIG. 10B together, the mesh pattern MP of an embodiment may further include an additional cut portion CT-A, in addition to the boundary cut portion CT provided between the first sensing unit SP1 and the second sensing unit SP2 described above. The additional cut portion CT-A may not be provided at the boundary of the first sensing unit SP1 and the second sensing unit SP2, but instead is provided inside the sensing units SP1 and SP2. For example, the additional cut portion CT-A may be provided in the region D1 illustrated in FIG. 9, in other words, in an inner region of the second sensing unit SP2. Unlike what is illustrated in FIG. 9 and FIG. 10B, the additional cut portion CT-A may be provided in an inner region of the first sensing unit SP1.

The additional cut portion CT-A may have the same shape as that of the boundary cut portion CT described above. In the mesh pattern MP of an embodiment, at least one of the plurality of visual patterns VP may be disposed to overlap the additional cut portion CT-A in one direction. For example, as illustrated in FIG. 10B, any one of the first visual patterns VP1 disposed on one side of the first mesh lines ML1 may overlap a first additional cut portion CT1-A in the second direction DR1, any one of the second visual patterns VP2 disposed on one side of the second mesh lines ML2 may overlap a second additional cut portion CT2-A in the first direction DR1, and any one of the third visual patterns VP3 disposed on one side of the third mesh lines ML3 may overlap a third additional cut portion CT3-A in the first direction DR1. Additionally, any one of the first additional cut portion CT1-A, the second additional cut portion CT2-A, and the third additional cut portion CT3-A may be omitted.

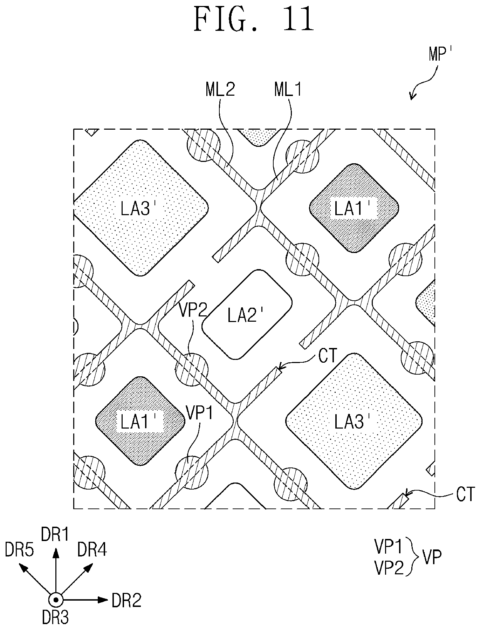

FIG. 11 is a plan view of a portion of a mesh pattern according to an embodiment of the inventive concept. FIG. 11 illustrates a mesh pattern MP' disposed corresponding to a display panel having a different pixel arrangement from that of the embodiments illustrated in FIG. 7 to FIG. 10B, and the shape of a visual pattern VP formed in the mesh pattern MP'.

Referring to FIG. 11, the display panel DP (see FIG. 4) may include first to third light emitting regions LA1', LA2', and LA3', and each of the first to third light emitting regions LA1', LA2', and LA3' may be provided in plural and be arranged in a predetermined arrangement on a plane. A first light emitting region LA1', a second light emitting region LA2', and a third light emitting region LA3 may be referred to as one pixel unit. The pixel unit including the first light emitting region LA1', the second light emitting region LA2', and the third light emitting region LA3' may be provided in plural and be arranged along the first direction DR1 and the second direction DR2.

The first light emitting regions LA1', the second light emitting regions LA2', and the third light emitting regions LA3' may be arranged along the first direction DR1 and the second direction DR2 on a plane. In each of the first direction DR1 and the second direction DR2, the first light emitting regions LA1' and the third light emitting regions LA3' may be alternately arranged with each other. The second light emitting regions LA2' may be arranged along each of the first direction DR1 and the second direction DR2. Each of the first light emitting region LA1' and the third light emitting region LA3', and the second light emitting region LA2' may be disposed spaced apart along a first diagonal direction DR4, which is a direction between the first direction DR1 and the second direction DR2, or along a second diagonal direction DR5 intersecting the first diagonal direction DR4.

The first light emitting regions LA1' and the second light emitting regions LA3' arranged along the first direction DR1 may be referred to as a "first light emitting column," and the second light emitting regions LA2' arranged along the first direction DR1 may be referred to as a "second light emitting column." Each of the first light emitting column and the second light emitting column may be provided in plurality, and be alternately arranged along the second direction DR2.

The mesh pattern MP' may include a first mesh line ML1 extended along the first diagonal direction DR4, and a second mesh line ML2 extended along the second diagonal direction DR5. Each of the first mesh line ML1 and the second mesh line ML2 may not overlap the first to third light emitting regions LA1, LA2, and LA3. Each of the first mesh line ML1 and the second mesh line ML2 may overlap the non-light emitting region NLA (see FIG. 4).

The mesh pattern MP' may include a cut portion CT provided in at least one of the first mesh line ML1 or the second mesh line ML2, and a plurality of visual patterns VP disposed on one side of the first mesh line ML1 and the second mesh line ML2. The plurality of visual patterns VP may include a first visual pattern VP1 disposed on one side of the first mesh line ML1 and a second visual pattern VP2 disposed on one side of the second mesh line ML2. The same contents described with reference to FIG. 7 to FIG. 10B may be applied to the cut portion CT and the plurality of visual patterns VP.

According to an embodiment of the present invention, a defect in which a partial region of a metal mesh pattern of an input sensing layer included in a display device is visually recognized from the outside is prevented. Therefore, the visibility of the input sensing layer including the mesh metal pattern and the visibility of the display device may be improved.

In addition, since a plurality of cut patterns are not formed in the metal mesh pattern to prevent the visual recognition defect, resistance of the metal mesh pattern may be prevented from excessively increasing, thereby preventing degradation in touch sensing performance due to an increase in resistance.

Although the inventive concept has been described with reference to embodiments thereof, it will be understood by those skilled in the art that various changes in form and detail may be made thereto without departing from the scope of the inventive concept as set forth in the following claims.

## Claims

1. A display device comprising:
a display panel (DP) including a plurality of light emitting regions (LA1, LA2, and LA3); and
an input sensing layer (ISP) disposed on the display panel, and including a plurality of sensing units (SP1, SP2),
wherein each of the plurality of sensing units (SP1, SP2) includes:
a plurality of mesh lines (ML1, ML2, and ML3) in which a plurality of openings (OP1, OP2, OP3) respectively overlapping the plurality of light emitting regions (LA1, LA2, and LA3) are defined; and
a plurality of visual patterns (VP) protruding from the plurality of mesh lines (ML1, ML2, and ML3) towards one of the plurality of light emitting regions or recessed away from one of the plurality of light emitting regions,
wherein:
a cut portion (CT1, CT2, CT3) connecting two adjacent openings (OP1, OP2, OP3) among the plurality of openings is provided in the plurality of mesh lines (ML1, ML2, and ML3); and
at least one of the plurality of visual patterns (VP) overlaps the cut portion (CT1, CT2, CT3) in one direction.

2. The display device of claim 1, wherein each of the plurality of visual patterns (VP) protrudes towards one of the plurality of light emitting regions (LA1, LA2, and LA3).

3. The display device of claim 1 or 2, wherein a height by which each of the plurality of visual patterns (VP) protrudes from the plurality of mesh lines (ML1, ML2, and ML3) is 1 micrometer to 5 micrometers.

4. The display device of claim 2 or 3, wherein each of the plurality of visual patterns (VP) has a semi-circular or semi-elliptical shape.

5. The display device of claim 2 or 3, wherein each of the plurality of visual patterns (VP) has a rectangular shape with rounded corners.

6. The display device of any of claims 2 to 5, wherein a height by which each of the plurality of visual patterns (VP) protrudes from the plurality of mesh lines (ML1, ML2, and ML3) is less than a distance from each of the plurality of mesh lines to each of the plurality of light emitting regions.

7. The display device of claim 1, wherein each of the plurality of visual patterns (VP) is recessed from one of the plurality of light emitting regions.

8. The display device of claim 1, wherein the plurality of visual patterns (VP) comprise:
a plurality of protruding visual patterns that protrude towards one of the plurality of light emitting regions; and
a plurality of recessed visual patterns that are recessed away from one of the plurality of light emitting regions.

9. The display device of any of the preceding claims, wherein the plurality of mesh lines (ML1, ML2, and ML3) comprise a first mesh line (ML1) and a second mesh line (ML2) surrounding one light emitting region among the plurality of light emitting regions,
wherein:
the first mesh line is extended in a first direction (DR2); and
the second mesh line is extended in a second direction (DR2) intersecting the first direction.

10. The display device of claim 9, wherein the plurality of visual patterns (VP) comprise:
a first visual pattern (VP1) protruding or recessed from the first mesh line (ML1) in the second direction (DR2); and
a second visual pattern (VP1) protruding or recessed from the second mesh line (ML2) in the first direction (DR2).

11. The display device of claim 10, wherein:
the first visual pattern comprises:
a 1-1 visual pattern (VP1-1) protruding from the first mesh line; and
a 1-2 visual pattern (VP1-2) protruding from the first mesh line, and disposed side by side with the 1-1 visual pattern in the first direction; and
the second visual pattern comprises:
a 2-1 visual pattern (VP2-1) protruding from the second mesh line; and
a 2-2 visual pattern (VP2-2) protruding from the second mesh line, and disposed side by side with the 2-1 visual pattern in the second direction.

12. The display device of any of the preceding claims, wherein each of the plurality of visual patterns (VP) comprises:
a first visual surface (VP-S1) extended from one side of one of the plurality of mesh lines, and having a first slope; and
a second visual surface (VP-S2) extended from the first visual surface, and having a second slope different from the first slope.

13. The display device of any of the preceding claims, wherein the plurality of light emitting regions comprise:
a first light emitting region (LA1) configured to emit first color light;
a second light emitting region (LA2) configured to emit second color light different from the first color light; and
a third light emitting region (LA3) configured to emit third color light different from the first color light and the second color light,
wherein a wavelength range of the third color light is smaller than a wavelength range of the first color light and a wavelength range of the second color light.

14. The display device of any of the preceding claims, wherein the plurality of sensing units include:
first sensing units (SP1) extended in a first direction; and
second sensing units (SP1) extended in a second direction intersecting the first direction,
wherein the cut portion (CT1, CT2, CT3) includes a boundary cut portion (CT) provided between one first sensing unit among the first sensing units and one second sensing unit among the second sensing units.

15. The display device of claim 14, wherein the cut portion (CT1, CT2, CT3) further comprises an additional cut portion (CT-A) inside of at least one of the first sensing units or the second sensing units.
